# EUROPEAN PATENT SPECIFICATION

(11) **EP 4 510 446 B1**
(45) Date of publication and mention of the grant of the patent: **18.02.2026**
(21) Application number: 23306374.2
(22) Date of filing: 14.08.2023
(51) Int. Cl.: H01L 23/367, H03F 1/02, H03F 3/60, H03F 3/195, H01L 23/66, H03F 3/24, H03F 3/72, H01L 23/495, H01L 23/538, H01L 23/00

(54) **AMPLIFIER DEVICES HAVING MULTIPLE BIAS NETWORKS**
VERSTÄRKERVORRICHTUNGEN MIT MEHREREN VORSPANNUNGSNETZWERKEN
DISPOSITIFS AMPLIFICATEURS AYANT DE MULTIPLES RÉSEAUX DE POLARISATION

(43) Date of publication of application: 19.02.2025
(73) Proprietor: NXP USA, Inc., Austin TX 78735 (US)
(72) Inventor: Lamy, Anthony, 31023 Toulouse (FR)
(74) Representative: Miles, John Richard

(56) References cited:
- US-A1- 2009 045 877
- US-A1- 2011 183 636
- US-A1- 2018 175 800
- US-A1- 2019 140 600
- WANG HUA ET AL: "The Wireless Workhorse: Mixed-Signal Power Amplifiers Leverage Digital and Analog Techniques to Enhance Large-Signal RF Operations", IEEE MICROWAVE MAGAZINE, IEEESERVICE CENTER, PISCATAWAY, NJ, US, vol. 16, no. 9, 1 October 2015 (2015-10-01), pages 36 - 63, XP011668279, ISSN: 1527-3342, [retrieved on 20150903], DOI: 10.1109/MMM.2015.2453872

## Description

### TECHNICAL FIELD

Embodiments of the subject matter described herein relate generally to RF amplifiers.

### BACKGROUND

High-efficiency radio-frequency (RF) amplifiers are increasingly finding use in communications applications. These high-efficiency RF amplifiers are desired because of the lower system size and cost achieved by the need for less cooling capability and because of the reduced energy needed to power these communications applications. Conventional high efficiency amplifiers (e.g., tuned class-AB) are operated at constant power supply voltages. Moreover, conventional high efficiency RF amplifiers are operated in a backed-off power condition. This backed-off power condition lowers amplifier efficiency.

Conventional high efficiency RF amplifiers may experience periods of low traffic conditions. This often means that the amplifiers have reduced efficiency because the amount of amplifier back off increases. This reduced efficiency results in excess energy usage. Thus, amplifier devices with improved efficiency are desired.
US 2018/175800 A1 discloses a Doherty amplifier where, in a low-power state, carrier amplifiers are selectively enabled as needed, peaking amplifiers are not enabled, and carrier amplifier bias levels are kept substantially constant. In an intermediate-power state, all carrier amplifiers are enabled, peaking amplifiers are selectively enabled, and bias levels are kept substantially constant. In a high-power state, all carrier and peaking amplifiers can be enabled, and the peaking amplifier bias tracks the RF envelope of the received RF signal.
US 2019/140600 A1 discloses an amplifier arrangement for amplifying an input signal to an output signal for delivering to a load. The amplifier arrangement comprises a power splitter configured to receive the input signal and produce split input signals. The amplifier arrangement further comprises a first amplifier branch comprising multiple main amplifier circuits. Output signals of the multiple main amplifier circuits are combined to generate a first output signal. The amplifier arrangement further comprises a second amplifier branch comprising at least one auxiliary amplifier circuit. The at least one auxiliary amplifier circuit is configured to receive a split input signal from the power splitter and produce a second output signal. The amplifier arrangement further comprises a power combiner configured to receive the first and second output signals and produce the output signal for delivering to the load. US 2009/045877 A1 discloses a multi-frequency and multi-mode power amplifier. The amplifier has a carrier power amplifier and a peaking power amplifier. The carrier power amplifier receives a first signal and outputs a first amplified signal, in which a first transistor size adjusting unit is included to adjust an equivalent transistor size based on a mode indication signal. The peaking power amplifier receives a second signal and outputs a second amplified signal, in which a second transistor size adjusting unit is included to adjust an equivalent transistor size based on the mode indication signal.
US 2011/183636 A1 discloses a circuit including a carrier amplifier having an input, an output, a first transistor coupled to a first power supply voltage terminal for receiving a modulated power supply voltage, and a second transistor coupled to a second power supply voltage terminal for receiving a fixed power supply voltage. The circuit further includes a peaking amplifier having an input coupled to the input of the carrier amplifier and an output coupled to the output of the carrier amplifier.
WANG HUA ET AL: "The Wireless Workhorse: Mixed-Signal Power Amplifiers Leverage Digital and Analog Techniques to Enhance Large-Signal RF Operations", IEEE MICROWAVE MAGAZINE, IEEESERVICE CENTER, PISCATAWAY, NJ, US, vol. 16, no. 9, 1 October 2015, pages 36-63, discloses a digital Doherty PA architecture in which the gains and phases of the two paths can be independently programmed in a digital fashion. The gain programmability can be realized by implementing the carrier/peaking PAs as two RF power DACs; and the phase tunability can be achieved by employing varactor loads in the PA drivers, whose tuning voltages can be generated using on-chip or off-chip DACs.

### BRIEF DESCRIPTION OF THE DRAWINGS

A more complete understanding of the subject matter may be derived by referring to the detailed description and claims when considered in conjunction with the following figures, wherein like reference numbers refer to similar elements throughout the figures.
FIGs 1A and 1B are simplified schematic diagrams of an amplifier device in accordance with an example embodiment;
FIG. 2 is a graphical representation depicting operation of the amplifier device of FIGs 1A and 1B;
FIG. 3 is a schematic diagram of an amplifier device in accordance with an embodiment;
FIG. 4 is a schematic diagram of an amplifier device in accordance with an embodiment;
FIGs 5A is a top-down, plan view of an apparatus and FIG. 5B is a cross-sectional side view along cutline 5B-5B of FIG. 5A, in accordance with an embodiment;
FIG. 6A is a top-down, plan view of an amplifier device in accordance with an embodiment and FIG. 6B is an isometric view of an amplifier device in accordance with an embodiment;
FIG. 7A is a top-down, plan view of an amplifier device in accordance with an embodiment and FIG. 7B is an isometric view of the amplifier device in accordance with an embodiment;
FIGs 8A, 8B, 8C, and 8D are graphical representations depicting operation of the amplifier device of FIG. 5; and
FIGs 9A, 9B, 9C, 9D, 9E, and 9F are graphical representations depicting operation of the amplifier device of FIG. 5 in comparison to a conventional amplifier device.

### SUMMARY

According to the invention there is provided an amplifier device as defined by the appended claims.

### DETAILED DESCRIPTION

The amplifier device embodiments provided herein may overcome some or all of the aforementioned issues with high-efficiency amplifiers. Specifically, the amplifier device embodiments described herein are configured to allow biasing of transistors within amplifier devices in deep class-C bias to effectively reduce the total size of the active transistors within the amplifier. Such biasing for reduced effective size of active transistors may be useful for increasing the efficiency of amplifier devices during times of low-power operation (e.g., during low traffic in a radio network).

The following detailed description is merely illustrative in nature and is not intended to limit the embodiments of the subject matter or the application and uses of such embodiments. As used herein, the words "exemplary" and "example" mean "serving as an example, instance, or illustration." Any implementation described herein as exemplary, or an example is not necessarily to be construed as preferred or advantageous over other implementations. Furthermore, there is no intention to be bound by any expressed or implied theory presented in the preceding technical field, background, or the following detailed description.

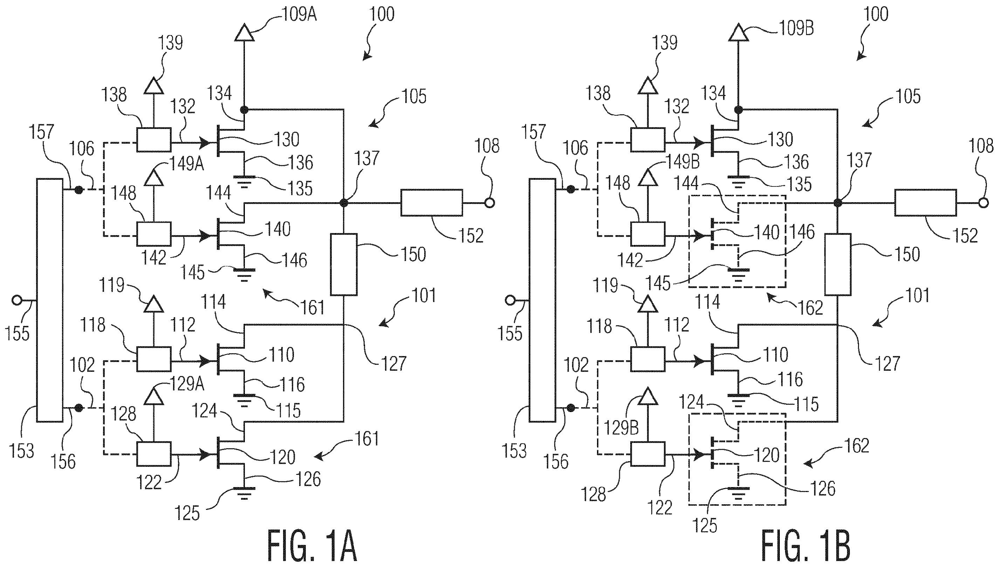

FIGs 1A and 1B, collectively referred to as FIG. 1, are, respectively, simplified schematic diagrams of an amplifier device 100 in a high-power state 161 (i.e., "first state") and a low-power state 162 (i.e., "second state"), in accordance with an example embodiment. In an embodiment an amplifier device 100 may include a first amplifier 101 electrically coupled to a first input terminal 102 and to a first output terminal 127.

First amplifier 101 includes a first field effect transistor 110 (i.e., "first transistor") that includes a first gate electrode 112 (i.e., "first control electrode"), a first drain electrode 114 (i.e., "first current-carrying electrode"), and a first source electrode 116 ("i.e. second current-carrying electrode"), configured to support a current flow between the first drain electrode 114 and the first source electrode 116, wherein the first gate electrode 112 physically and electrically separates the first source electrode 116 and the first drain electrode 114 and may be configured to control current flow in a variable conductivity channel between the first drain electrode 114 and the first source electrode 116, wherein the gate electrode is radio frequency (RF) coupled to the first input terminal 102, and wherein the first drain electrode 114 is electrically coupled to the first output terminal 127. In an embodiment, the first source electrode 116 of first transistor 110 may be electrically coupled to ground potential 115.

A first bias network 118 is electrically coupled to the first gate electrode 112, wherein the first bias network 118 is configured to apply a first direct current (DC) bias 119 (i.e., "first bias") to the first gate electrode 112 and is RF-isolated from the first gate electrode 112. As used herein, the term "RF-isolated" means that radio-frequency (RF) coupling between two components that are RF-isolated is less than -20 dB, according to an embodiment. In other embodiments, RF coupling between two components that are RF-isolated is less than -10 dB, though higher or lower values may be used. A second field effect transistor 120 (i.e., "second transistor") that includes a second gate electrode 122 (i.e., "second control electrode"), a second drain electrode 124 (i.e., "third current-carrying electrode"), and a second source electrode 126 (i.e., "fourth current-carrying electrode"), is configured to support a current flow between the second drain electrode 124 and the second source electrode 126, wherein the second gate electrode 122 is be configured to control the current flow between the second drain electrode 124 and the second source electrode 126, wherein the second gate electrode 122 is RF coupled to the first input terminal 102, wherein the second drain electrode 124 is electrically coupled to the first output terminal 127. A second bias network 128 is electrically coupled to the second gate electrode 122, wherein the second bias network 128 is configured to apply a second DC bias 129A/129B to the second gate electrode 122 and is RF-isolated from the second gate electrode 122. In an embodiment, the source electrodes 126 of second transistor 120 may be electrically coupled to ground potential 125.

Still referring to FIG. 1, the amplifier device 100 includes a second amplifier 105 electrically coupled to a second input terminal 106 and a second output terminal 137. The second amplifier 105 includes a third transistor 130 that may include a third gate electrode 132, a third drain electrode 134, and a third source electrode 136. The third transistor 130 is configured to support a current flow between the third drain electrode 134 and the third source electrode 136, wherein the third gate electrode 132 is configured to control current flow between the third drain electrode 134 and the third source electrode 136, wherein the third control electrode is RF coupled to the second input terminal 106, and wherein the third drain electrode 134 is electrically coupled to the second output terminal 137. A third bias network 138 is electrically coupled to the third gate electrode 132, wherein the third bias network 138 is configured to apply a third DC bias 139 to the third gate electrode and is RF-isolated from the third gate electrode. In an embodiment, the source electrode 136 of third transistor 130 may be electrically coupled to ground potential 135.

A fourth transistor 140 that includes a fourth gate electrode 142, a fourth drain electrode 144, and a fourth source electrode 146, is configured to support a current flow between the fourth drain electrode 144 and the fourth source electrode 146, wherein the fourth gate electrode 142 is configured to control the current flow between the fourth drain electrode 144 and the fourth source electrode 146, wherein the fourth gate electrode 142 is radio frequency (RF) coupled to the second input terminal 106, and wherein the fourth drain electrode 144 is electrically coupled to the second output terminal. A fourth bias network 148 electrically coupled to the fourth gate 142 electrode, wherein the fourth bias network 148 is configured to apply fourth DC bias 149A/149B to the fourth gate electrode 142 and is RF-isolated from the fourth gate electrode 142. In an embodiment, the source electrode 146 of fourth transistor 140 may be electrically coupled to ground potential 145.

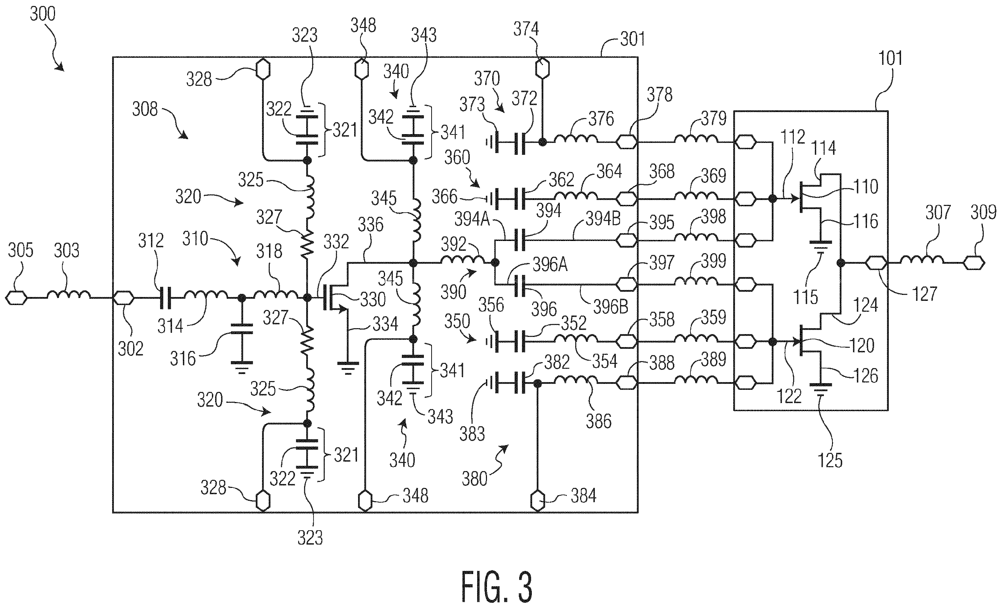

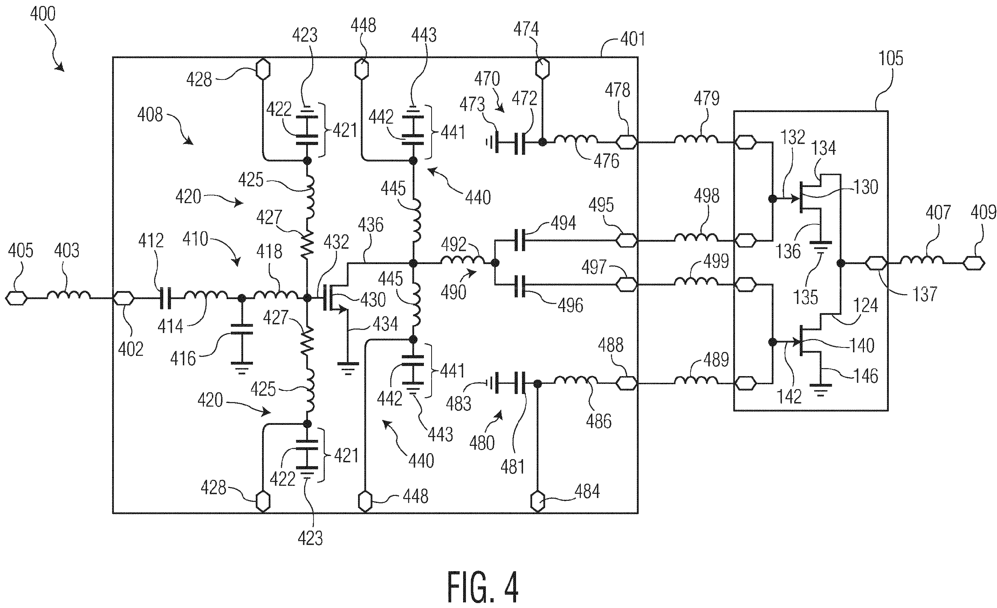

In an embodiment, the first, second, third, and fourth transistors 110, 120, 130, 140 may include field effect transistors (FET's) (such as heterojunction FET's (HFET's), metalsemiconductor FET's (MESFET's), or metal oxide semiconductor FET's (MOSFET's)), each of which include a gate (control terminal), a source (a first current-carrying terminal), and a drain (a second current-carrying terminal). For convenience of explanation and not for limitation, various embodiments of the invention will be illustrated using GaN HFET active devices for amplifier device 100 and silicon laterally diffused metal oxide semiconductor devices (LDMOS) devices for the driver amplifiers 308, 408 of FIGs 3 and 4, which are preferred. However, many other active device types may also be employed and are intended to be included within the scope of the invention, as for example and not intended to be limiting, bipolar devices, junction field effect devices, various insulated gate field effect devices, and so forth. Alternatively, the first, second, third, and fourth transistors 110, 120, 130, and 140 may include a bipolar junction transistors (BJT) or a heterojunction BJT (HBT). Accordingly, references herein to a "gate," "drain," and "source," are not intended to be limiting, as each of these designations has analogous features for a bipolar device implementation (e.g., a base, collector, and emitter, respectively).

In an embodiment, the first transistor 110 may have a total gate width of between about 0.5 and about 50 millimeters (mm) (e.g., about 1 mm), although higher or lower values of the total gate width may be used in some embodiments. In an embodiment, first, second, third, and fourth transistors 110, 120, 130, and 140 have an input capacitance (i.e., gate-source capacitance) between first, second, third, and fourth gate electrodes 112, 122, 132, and 142 and first, second, third, and fourth source electrodes 116, 126, 136, and 146 of the first, second, third, and fourth transistors 110, 120, 130, 140. In an example embodiment, the first, second, third, and fourth transistors 110, 120, 130, 140 have a gate source capacitance between about 0.5 pF per millimeter of gate periphery (pF/mm) and about 3.5 pF/mm (e.g., 2.5 pF/mm), though higher or lower values may be used. In an embodiment, the first second, third, and fourth transistors 110, 120, 130, and 140 have an output capacitance (i.e., drain-source capacitance) between first, second, third, and fourth drain terminals 114, 124, 134, 144 and first, second, third, and fourth source electrodes 116, 126, 136, and 146. In an embodiment, first. second, third, and fourth transistors 110, 120, 130, and 140 have a drain-source capacitance between about 0.2 pF per millimeter of gate periphery (pF/mm) and about 1 pF/mm (e.g., about 0.4 pF/mm), though other higher or lower values may be used.

First and second amplifiers 101 and 105 may be combined in a Doherty configuration. To this end, a transmission line 150 may be used in conjunction with the output capacitances of first, second, third, and fourth transistors 110, 120, 130, and 140 to achieve a phase shift between the outputs 127 and 137 of first and second amplifiers 101 and 105. Transmission line 150 may be configured to electrically couple the first output terminal 127 and the second output terminal 137, according to an embodiment. In an embodiment, the phase shift may be between about 80 and 100 degrees. In an embodiment, the phase shift introduced in part by transmission line 150 may be added to phase shift arises from capacitive loading of the output capacitance of first, second, third and fourth transistors 110, 120, 130, and 140 as well as additional inductance coupled in series at one or more ends of the transmission line 150 (not shown). Thus, a transmission line phase shift due only to transmission line 150 may be less than the phase shift and may be to achieve the desired amount of phase shift. For example, the transmission line phase shift may be, e.g., 20 degrees to 50 degrees, but due to output capacitance of transistors 110, 120, 130, 140, and possibly additional capacitors and inductors (not shown), the phase shift may be approximately 90 degrees, e.g., 80 and 100 degrees. In other embodiments, the phase shift may have higher or lower values, e.g., 30 to 120 degrees, depending on the application. In an embodiment, an impedance transformer 152 may be electrically coupled to second output 137 that creates a summing node at second output 137 and to output terminal 108. As used herein, the term "summing node" refers to a point at which a peaking amplifier is electrically connected to a carrier or main amplifier in, e.g., a Doherty amplifier configuration.

In other embodiments, the summing node and connection to impedance transformer 152 may be at the first output terminal 127. The first amplifier 101 is configured as a carrier amplifier and second amplifier 105 is configured as a peaking amplifier. In these embodiments, transmission lines having phase shifts approximating the phase difference of the splitter (e.g., 90 degrees) may be added to the carrier amplifier path and to the peaking amplifier path (not shown). A splitter 153 having a splitter input 155, a first splitter output 156, and a second splitter output 157 may be configured to divide a signal delivered to the splitter input 155 between the first splitter output 156 and the second splitter output 157 with a splitter phase difference between the first splitter output 156 and the second splitter output 157, according to an embodiment. In an embodiment, the splitter phase difference may be between about 45 degrees and about 135 degrees. In an embodiment, a difference between the splitter phase difference and the phase shift associated with transmission line 150 and second splitter output 157 may be less than twenty percent of the splitter phase difference. The first amplifier 101 is configured as a carrier amplifier and the second amplifier 105 is configured as a peaking amplifier in a Doherty amplifier configuration.

The first and second amplifiers 101, 105 may be configured to operate in high power state 161 depicted in FIG. 1A and to operate in a low-power state 162 depicted FIG. 1B. When operating in high-power state 161, the first and third transistors 110 and 130 and the second and fourth transistors 120 and 140 are operated with first and third biases 119, 139 applied to the first and third bias networks 118, 138 and second and fourth biases 129A, 149A applied to the second and fourth bias networks 128, 148. During saturated operation of amplifier device 100, an RF current of an least fifty percent of the maximum current of the second and fourth transistors 120, 140 flows from the second and fourth drain electrodes 124, 144 (i.e., "third and seventh current-carrying electrodes") to the second and fourth source electrodes 126, 146 (i.e., "fourth and eighth current-carrying electrodes") of the second and fourth transistors 120, 140 when the first and third transistors 110, 130 are operated at a saturated output power, and a fifth bias 109A is applied to the first, second, third, and fourth drain electrodes 114, 124, 134, 144, (i.e., "first, third, fifth, and seventh current-carrying electrodes"). When operating in the low-power state 162 of FIG. 1B, the first and third transistors 110, 130 and the second and fourth transistors 120, 140 are operated with first and third biases 119, 139 applied to the first and third bias networks 118, 138 and second and fourth biases 129B, 149B applied to the second and fourth bias networks 128, 148 such that an RF current of less than ten percent of the maximum current of the second and fourth transistors 120, 140 flows through the second and fourth transistors 120, 140 when the first and third transistors 110, 130 are operated at a saturated output power. In other examples, and when operating in the low-power state 162 of FIG. 1B, the first and third transistors 110, 130 and the second and fourth transistors 120, 140 may be operated with first and third biases 119, 139 applied to the first and third bias networks 118, 138 and second and fourth biases 129B, 149B applied to the second and fourth bias networks 128, 148 such that an RF current of less than one percent of the maximum current of the second transistor flows through the second and fourth transistors 120, 140 when the first and third transistors 110, 130 are operated at a saturated output power, according to an embodiment. In an embodiment, a magnitude of a difference in the magnitude of a saturated efficiency in the high-power state 161 (i.e., "first state") and an efficiency in the second state 162 may be less than twenty percent of the efficiency in the high-power state 161. A fifth bias 109B is applied to the first, second, third, and fourth drain electrodes 114, 124, 134, 144, (i.e., "first, third, fifth, and seventh current-carrying electrodes") when operating in the low-power state 162. In an embodiment, the fifth bias 109B may be a lower value (e.g., 28V) than the fifth bias 109A (e.g., 48V) when operating in the low-power state 162.

In an embodiment, amplifier device 100 may be operated in a transmitter system, wherein individual power supplies (not shown) may be used to supply first bias 119, second bias 129, third bias 139A/139B, fourth bias 149A/149B, and fifth bias 109A/109B. According to an embodiment, a bias controller (not shown) may be used to control the voltage levels provided for first bias119, second bias 129A/129B, third bias 139, fourth bias 149A/149B, and fifth bias 109A/109B. In an embodiment, the bias controller may sense the traffic level in the amplifier system and, therefore, the output power required for amplifier device 100. As a result, the bias voltages applied to first and third biases 119, 139, second and fourth biases, 129A/129B, 149A/149B, and fifth bias 109A/109B, may be adjusted to optimize the efficiency of amplifier device 100.

For example, and in and in an embodiment, where first amplifier 101 is configured as a carrier amplifier and second amplifier 105 is configured as a peaking amplifier with first, second, third and fourth transistors 110, 120, 130, and 140 based on gallium nitride (GaN) transistor technology, the first, second, and fifth biases 119, 129A, 109A corresponding to high-power state 161 may include a gate voltage (e.g., gate bias of -2.5 V to -2.9V or approximately 0.1 to 0.5 V above a threshold voltage of -3V) that corresponds to a class A-B quiescent drain current bias, e.g., less than five percent of the full channel current of first transistor 110, and fifth bias 109A applied to the first, second, third, and fourth drain electrodes 114, 124, 134, 144 (e.g. a drain voltage of 48V) that corresponds to high-power operation, according to an embodiment. Likewise, the third and fourth biases 139, 149A of third and fourth transistors 130 and 140 of second amplifier 105 may include a gate voltage that corresponds to a class C bias, e.g., approximately zero current with a gate bias between approximately 0.1V and 2V below a threshold voltage (e.g. -3.1 V to -2V for -3V threshold voltage), while fifth bias 109A (e.g. 50V) is applied to drain electrodes 134, 144 of the third and fourth transistors 130, 140 according to an embodiment.

For example, and in an embodiment, where first amplifier 101 is configured as a carrier amplifier and second amplifier 105 is configured as a peaking amplifier with first, second, third and fourth transistors based on gallium nitride (GaN) transistor technology, the first bias 119 corresponding to low-power state 162 may include a gate voltage (e.g., gate bias of approximately -2.5 V to -2.9V or approximately 0.1 to 0.5 V above a threshold voltage of - 3V) that corresponds to a class A-B bias, e.g., a quiescent drain current less than ten percent of the full channel current of first transistor 110, according to an embodiment. Likewise, the third bias 139 applied to third transistor 130 of second amplifier 105 may include a gate voltage that corresponds to a class C bias for transistor 130 (e.g., approximately zero current with a gate bias between approximately 0.1V and 1V below a threshold voltage (e.g. -3.1 V to -4V for -3V threshold voltage). The second and fourth biases 129B, 149B applied to the second and fourth bias networks 128, 148 may correspond to a deep class C condition (e.g., a gate bias of -8V, approximately 5V below the threshold voltage of approximately -3V) for second and fourth transistors 120, 140. Likewise, the fifth bias 109B applied to the first, second, third, fourth drain electrodes 114, 124, 134, 144 (e.g., a drain voltage of 28V) corresponds to low-power operation, according to an embodiment. In low-power state 162, the effect of the third and fourth biases 129B and 149B biasing transistors 120, 140 in deep class C may have the effect to reduce the overall effective gate periphery of first amplifier 101 and second amplifier 105 since the devices are operated in deep depletion and do not contribute current to the operation of amplifier device 100, according to an embodiment.

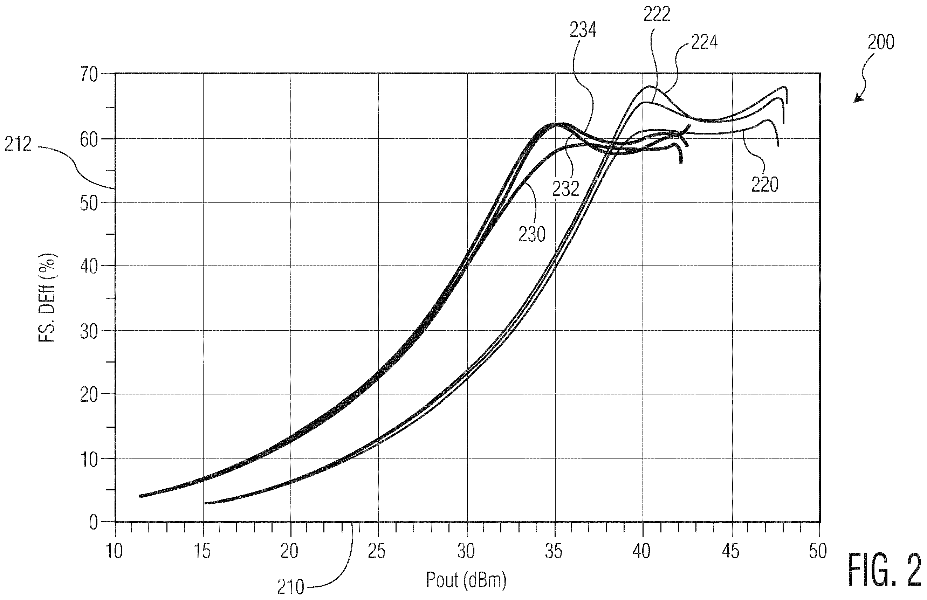

FIG. 2 is a graphical representation 200 depicting operation of the amplifier device 100 of FIGs 1A and 1B in high and low-power states 161, 162, according to an embodiment. Referring simultaneously to FIGs 1A, 1B, and FIG. 2, graphical representation 200 shows simulated drain efficiency 212 versus output power 210. Traces 220, 222, 224 represent efficiency versus output power at frequencies of 2.5 gigahertz (GHz), 2.6 GHz, and 2.7 GHz, respectively when amplifier device 100 is operated in high-power state 161. Traces 230, 232, 234 represent efficiency versus output power at frequencies of 2.5 GHz, 2.7 GHz, and 2.6 GHz, respectively when amplifier device 100 is operated in low-power state 162. In this example, first and second transistors 110 and 120 have total gate widths (i.e., unit gate width times the number of fingers) of 1 millimeter (mm) each while third and fourth transistors 130 and 140 have total gate widths of 1.75 mm each. Traces 220, 222, 224 show that during the high-power state 161 where first and second biases 119, 129A are set to achieve 8.5 mA/mm at a drain voltage of 48V is applied to first and second transistors 110, 120 and a class C bias of -3.9V with a drain bias of 48V is applied to the third and fourth transistors 130, 140, an efficiency of greater than 60% may be achieved over the power range of 40 dBm to 47 dBm, according to an embodiment. Traces 230, 232, 234 show that during the low-power state 162 where first bias 119 is set to achieve 8.5 mA/mm at a drain voltage of 28V is applied to first transistor 110, third bias 139 is set to a class C bias of -3.9V with a drain bias of 28V is applied to third transistor 130, and a deep class C bias of -8V is applied to second and fourth biases 129B and 149B to bias the second and fourth transistors 120, 140 to deep class C, an efficiency of greater than 58% over the power range of 35 to 42 dBm may be achieved, according to an embodiment. Thus, the dynamic range of the amplifier device 100 for achieving greater than 58% efficiency may be extended from about 8 dB to about 14 dB, according to an embodiment.

FIG. 3 is a schematic diagram of first power amplifier device 300 in accordance with an embodiment. First power amplifier device 300 (i.e., "first amplifier") may include a first amplifier 101 electrically coupled to a first input terminal 302 and to a first output terminal 127 and driver and bias circuitry 301 coupled the first amplifier 101. The first amplifier 101 may include a first field effect transistor 110 that includes a first gate electrode 112, a first drain electrode 114, and a first source electrode 116. First field effect transistor 110 may be configured to support a current flow between the first drain electrode 114 and the first source 116 electrode, wherein the first gate electrode 112 may be configured to control the current flow between the first drain electrode 114 and the first source electrode 116, wherein the gate electrode 112 may be RF-coupled to the first external input terminal 305, and wherein the first drain electrode 114 may be electrically coupled to the first output terminal 127 and to first external output terminal 309 via output wire bond 307, according to an embodiment. In an embodiment, a first bias network 370 that includes RF bypass capacitor 372 coupled to ground 373 and inductor 376 that may be electrically coupled to the first gate electrode 112 and may be configured to apply a first direct current (DC) bias via terminal 374, inductor 376, terminal 378, bond wire 379, and wherein the first bias network 370 to the first gate electrode 112 and may be RF-isolated from the first gate electrode 112. In an embodiment, RF bypass capacitor 372 may have a value between about 5 picofarads and about 100 picofarads, although other higher or lower values may be used. Inductor 376 may have a value of between about 5 nanohenries and about 100 nanohenries although other higher or lower values may be used, according to an embodiment.

In an embodiment, a second field effect transistor 120 may include a second gate electrode 122, a second drain electrode 124, and a second source electrode 126, configured to support a current flow between the second drain electrode 124 and the second source electrode 126, wherein the second gate electrode 122 may be configured to control the current flow between the second drain electrode 124 and the second source electrode 126, wherein the second gate electrode 122 may be RF-coupled to the first input terminal 302, wherein the second drain electrode 124 may be electrically coupled to the first output terminal 127. A second bias network 380 that includes RF bypass capacitor 382 coupled to ground 383 and inductor 386 may be electrically coupled to the first gate electrode through inductor 386, may be electrically coupled to the second gate electrode 122, wherein the second bias network 380 may be configured to apply a second DC bias to the second gate electrode 122 through terminal 384, inductor 386, terminal 388, and bond wire 389 and may be RF-isolated from the second gate electrode 122, according to an embodiment. In an embodiment, the values of components of second bias network 380 (e.g., RF bypass capacitor 382 and inductor 386) may be analogous to those of first bias network 370.

In an embodiment, circuitry 390 that includes a first capacitor 394 (i.e., "first coupling element") having a first terminal 394A and a second terminal 394B, may be electrically coupled to the first gate electrode 112 through terminal 395 and bond wire 398 by its second terminal 394B. A second capacitor 396 (i.e., "second coupling element") having a third terminal 396A and a fourth terminal 396B, may be electrically coupled by terminal 397 via the fourth terminal 396B and bond wire 399 to the second gate electrode 122. The first terminal 394A may be electrically coupled to the third terminal 396A, according to an embodiment. In an embodiment, a first input matching network that may include bond wires 369, 379, and 398 may be electrically coupled to the first gate electrode 112 through terminals 368, 378, 395 and may be configured to provide an impedance match for the first transistor 110 at a fundamental frequency. A second input matching network that may include bond wires 359, 389, and 399 may be electrically coupled to the second gate electrode 122 and may be configured to provide an impedance match for the second transistor 120 at the fundamental frequency.

An embodiment may include first and input harmonic matching networks 350, 360 that includes capacitors 352, 362 and inductors 354, 364 connected in series and electrically coupled to grounds 356, 366 and may be configured to provide a harmonic termination for the first transistor 110 at a harmonic frequency. An embodiment may also include input harmonic matching networks 350, 360 that may include capacitors 352, 362 and inductors 354, 364 connected in series and electrically coupled to ground 356, 366 and to terminals 358, 368 and is configured to provide a harmonic termination for the first and second transistors 110, 120 at the harmonic frequency. In an embodiment, capacitors 352, 362 may have values between about 0.3 picofarads and about 5 picofarads, although other higher or lower values may be used. Inductors 354, 364 may have values of between about 0.3 nanohenries and about 2 nanohenries although other higher or lower values may be used, according to an embodiment.

A driver amplifier 308 may be electrically coupled to the first terminal 394A of the first capacitor and the third terminal 396A of the second capacitor and may be RF-coupled to first input terminal 302 through series capacitor 312 and from first input terminal 302 to first external input terminal 305. Transistor 330 is the primary active device of driver amplifier 308 and includes a gate electrode 332, source terminal 334, and drain electrode 336. In an embodiment, driver amplifier 308 may be coupled to first external input terminal 305 through bond wire 303 and may include an input matching network 310 coupled to the gate electrode 332 of transistor 330, input bias networks 320 coupled to the gate electrode 332 and driver drain bias networks 340 coupled to the drain electrode 336 of the transistor 330. Driver amplifier 308 may be coupled to first and second capacitors 394 and 396 through inductor 392 which may be configured to provide impedance matching, according to an embodiment.

In an embodiment, input matching network 310 may include a "T" network that includes input match inductors 314, 318 that are electrically coupled together in series at a point coupled to ground by input match capacitor 316. Input match inductors 314, 318 may have values between about 0.1 nanohenries and about 5 nanohenries, according to an embodiment. Input match capacitor may have a value of between about 0.5 picofarads and about 2 picofarads, according to an embodiment. In an embodiment, input bias network 320 may include DC block 321 that includes RF bypass capacitor 322 and DC ground 323 may be electrically coupled to the gate electrode 332 through inductor 325 and resistor 327, wherein the input bias networks 320 may be configured to apply a first direct current (DC) bias to the gate electrode 332. In an embodiment, RF bypass capacitor 322 may have a value between about 2 picofarads and about 50 picofarads, although other higher or lower values may be used. Inductor 325 may have a value of between about 5 nanohenries and about 100 nanohenries although other higher or lower values may be used, according to an embodiment. Resistor 327 may have a value between about 1 ohm and about 1000 ohms, according to an embodiment. Terminal 328 is used to provide a connection of the input bias network to the DC gate bias. In an embodiment, driver drain bias networks 340 may include DC block 341 that includes RF bypass capacitor 342 and RF grounds 343 and may be electrically coupled to the drain electrode 336 through inductor 345, wherein the driver drain bias networks 340 may be configured to apply a first direct current (DC) bias to the drain electrode 336 through terminal 348. In an embodiment, RF bypass capacitor 342 may have a value between about 2 picofarads and about 50 picofarads, although other higher or lower values may be used. Inductor 345 may have a value of between about 5 nanohenries and about 100 nanohenries although other higher or lower values may be used, according to an embodiment.

FIG. 4 is a schematic diagram of a second power amplifier device 400 (i.e., "second amplifier") in accordance with an embodiment. Second power amplifier device 400 may include a second amplifier 105 and driver and bias circuitry 401 that may be electrically coupled to a second input terminal 402 and a second output terminal 137, according to an embodiment. In an embodiment, the second amplifier 105 may include a third transistor 130 that includes a third gate electrode 132, a third drain electrode 134 and a third source electrode 136, wherein the third gate electrode 132 may be RF coupled to the second input terminal, and wherein the third drain electrode may be electrically coupled to the second output terminal. A third bias network 470 that includes blocking capacitor 472, ground 473, and inductor 476 may be electrically coupled to the third gate electrode 132, wherein the third bias network 470 may be configured to apply a third DC bias to the third gate electrode 132 and may be RF-isolated from the third gate electrode 132. An embodiment may include a fourth transistor 140 that includes a fourth gate electrode 142, a fourth drain electrode 144, and a fourth source electrode 146, configured to support a current flow between the fourth drain electrode 144 and the fourth source electrode 146, wherein the fourth gate electrode 142 is configured to control the current flow between the fourth drain electrode 144 and the fourth source electrode 146, wherein the fourth gate electrode 142 may be radio frequency (RF) coupled to the second input terminal, and wherein the fourth drain electrode 144 may be electrically coupled to the second output terminal 137. A fourth bias network 480 that includes DC block 481, ground 483, and inductor 486 may be electrically coupled to the fourth gate electrode 142, wherein the fourth bias network 480 may be configured to apply a fourth DC bias applied at terminal 484 to the fourth gate electrode 142 through terminal 488 and may be RF-isolated from the fourth gate electrode 142, according to an embodiment.

In an embodiment, other components included in second power amplifier device 400, (e.g. second external input terminal 405, bond wire 403, second input terminal 402, bond wire 407, driver amplifier 408, output terminal 409, input matching network 410, input match inductors 414, 418, input match capacitor 416, input bias networks 420, DC block 421, RF bypass capacitor 422, DC ground 423, inductor 425, resistor 427, driver terminals 428, 448, transistor 430, transistor gate electrode 432, transistor drain electrode 436, transistor source electrode 434, output bias networks 440, DC block 441, RF bypass capacitor 442, RF ground 443, inductor 445, series capacitor 412, coupling circuitry 490, inductor 492, first capacitor 494, second capacitor 496, bond wires 479, 489, 498, 499) have been described in connection with first power amplifier device 300 in FIG. 3.

In this example embodiment, second power amplifier device 400 does not include input harmonic termination networks as are included in first power amplifier device 300 of FIG. 3 (e.g., input harmonic termination networks 350, 360). In other embodiments, harmonic termination circuitry may be included in second power amplifier device 400 (not shown).

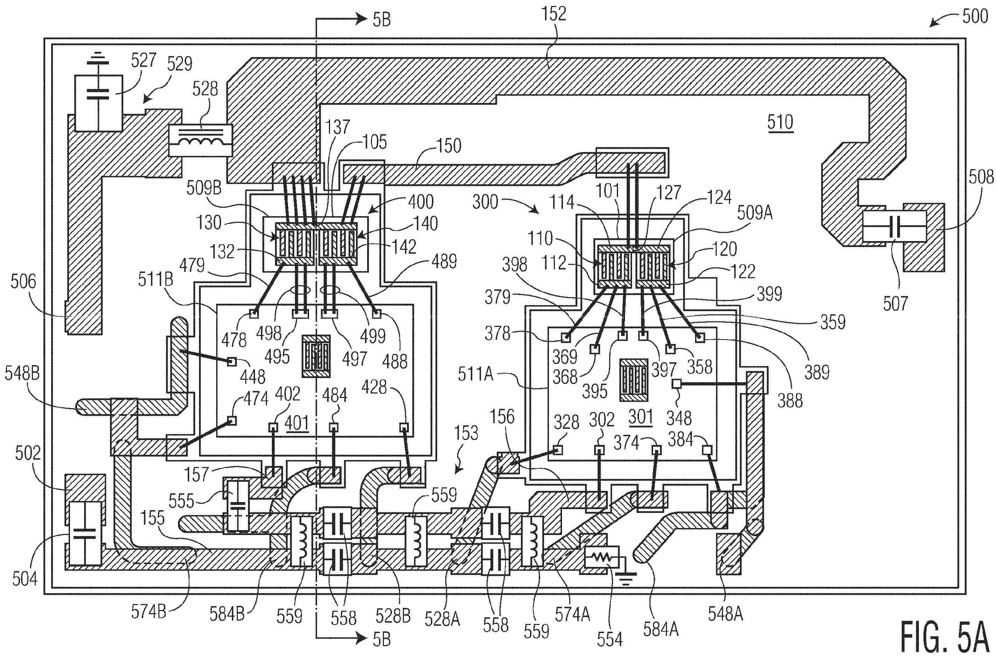

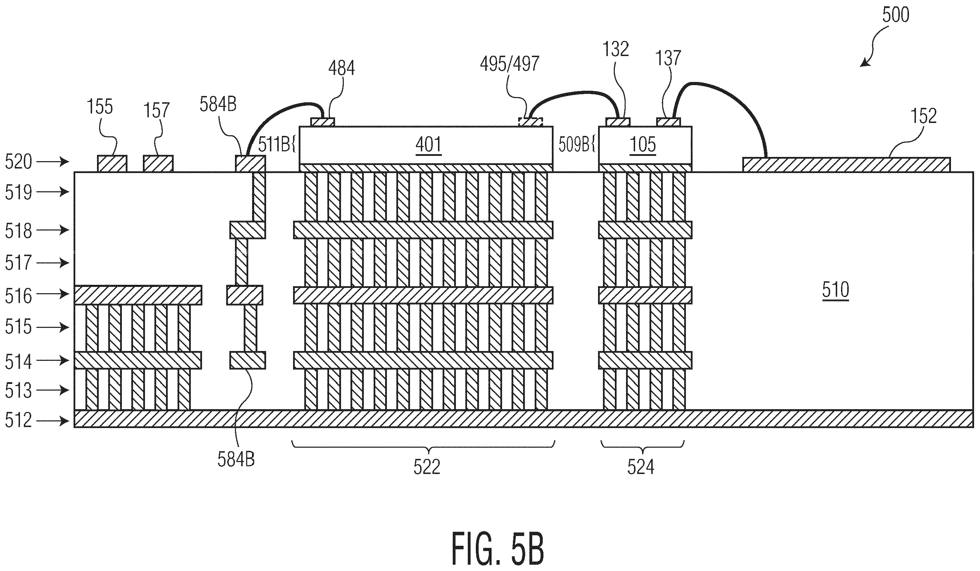

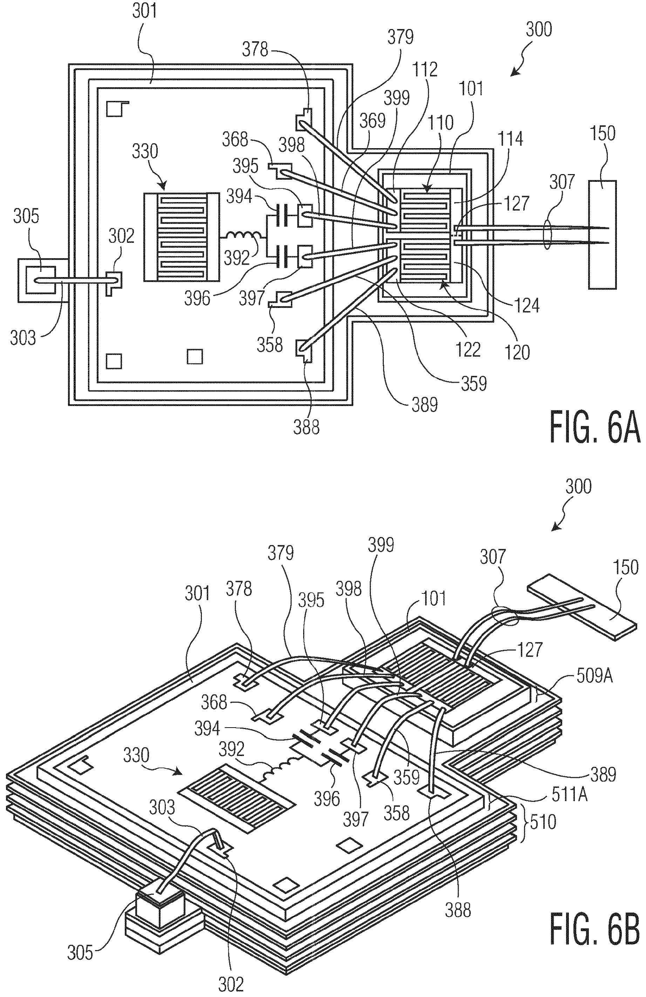

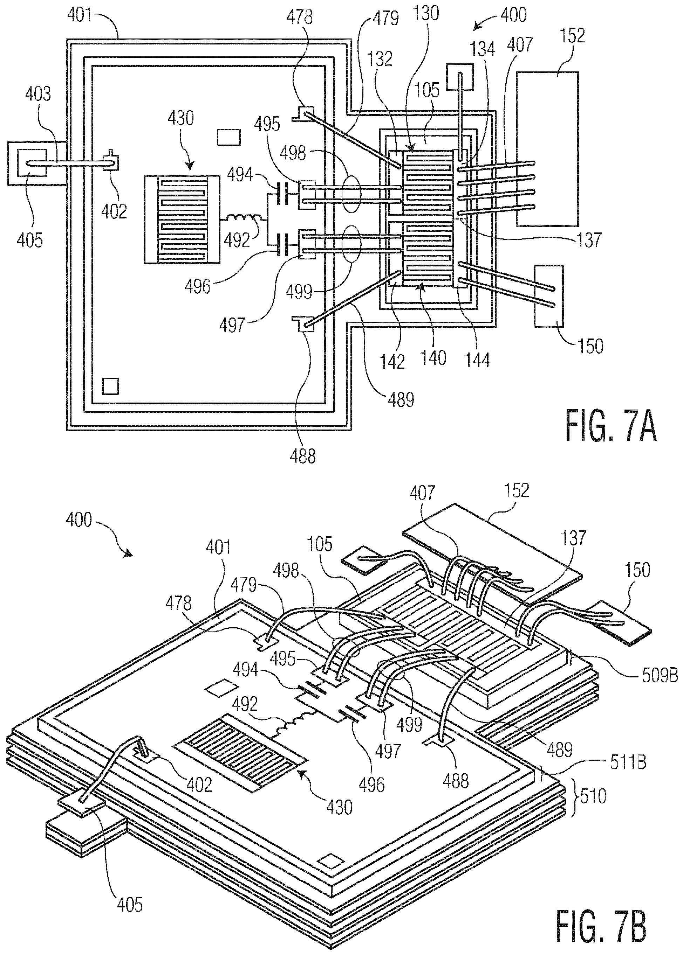

FIGs 5A is a top-down, plan view of an apparatus 500 and FIG. 5B is a cross-sectional side view along cutline 5B-5B of FIG. 5A, in accordance with an embodiment. FIGs 6A, 6B, 7A, and 7B are top-down plan and isometric view of portions of apparatus 500 in accordance with an embodiment. The features of apparatus 500 may be best understood by viewing FIGs 5A, 5B, 6A, 6B, 7A, and 7B simultaneously.

Apparatus 500 may include a base substrate 510, a first power amplifier device 300 coupled to the base substrate 510 and electrically coupled to a first input terminal 302 through driver and bias circuitry 301 and to a first output terminal 127. In an embodiment, the first amplifier 101 may include a first field effect transistor 110 that may include a first gate electrode 112, a first drain electrode 114, and a first source electrode 116 (not shown). A first bias network 370 (within driver and bias circuitry 301, not shown) may be electrically coupled to the first gate electrode 112 through bond wire 379, terminal 378, first bias network 370 (shown in FIG. 3), and may be configured to apply a first direct current (DC) bias to the first gate electrode 112 through terminal 374 from module terminal 574A, and may be RF-isolated from the first gate electrode, according to an embodiment. In an embodiment, a second field effect transistor 120 integrally formed with the first field effect transistor 110 may include a second gate electrode 122, a second drain electrode 124, and a second source electrode 126 (not shown). In an embodiment, the second gate electrode 122 may be RF-coupled to the first input terminal 302, wherein the second drain electrode 124 may be electrically coupled to the first output terminal. A second bias network 380 (shown within driver and bias circuitry 301 of FIG. 3) may be electrically coupled to the second gate electrode 122 through bond wire 389, terminal 388, wherein the second bias network 380 may be configured to apply a second DC bias provided through terminal 384 from module terminal 584A to the second gate electrode 122 and may be RF-isolated from the second gate electrode 122, according to an embodiment.

In an embodiment, a second power amplifier device 400 may be coupled to the base substrate 510 and may be electrically coupled to a second input terminal 402 and a second output terminal 137, wherein the second power amplifier device 400 may include a third transistor 130 that includes a third gate electrode 132, a third drain electrode 134, and a third source electrode 136 (not shown), configured to support a current flow between the third drain electrode 134 and the third source electrode 136 (see FIGs 4 and 7A). In an embodiment, a third bias network 470 (within driver and bias circuitry 401, not shown) may be electrically coupled to the third gate electrode 132 through terminal 478 and bond wire 479, wherein the third bias network 470 may be configured to apply a third DC bias provided to terminal 474 from module terminal 574B to the third gate electrode 132 and may be RF-isolated from the third gate electrode 132. A fourth transistor 140 may include a fourth gate electrode 142, a fourth drain electrode 144, and a fourth source electrode 146 (not shown) and is configured to support a current flow between the fourth drain electrode 144 and the fourth source electrode 146, wherein the fourth gate electrode 142 may be configured to control the current flow between the fourth drain electrode 144 and the fourth source electrode 146, wherein the fourth gate electrode 142 may be radio frequency (RF) coupled to the second input terminal 402 (through driver and bias circuitry 401), and wherein the fourth drain electrode 144 may be electrically coupled to the second output terminal 137, according to an embodiment (see FIGs 4 and 7A). In an embodiment, a fourth bias network 480 may be electrically coupled to the fourth gate electrode 142 through terminal 488 and bond wire 489, wherein the fourth bias network may be configured to apply a fourth DC bias through terminal 484 to module terminal 584B to the fourth gate electrode 142 and may be RF-isolated from the fourth gate electrode 142. Transmission line 150 formed over base substrate 510 may be configured to electrically couple the first output terminal 127 and the second output terminal 137, according to an embodiment. An impedance transformer 152 may be formed over the base substrate 510 and may be electrically coupled to a summing node at one of the first output terminal 127 and the second output terminal 137, according to an embodiment. Module drain terminal 506 may be coupled to impedance transformer 152 through bias network 529 that includes RF choke 528 and bypass capacitor 527, according to an embodiment. In the embodiment shown here, the summing node is at the second output terminal 137. Output terminal 508 may be coupled to impedance transformer 152 using coupling capacitor 507.

In an embodiment, the first transistor 110 and the second transistor 120 may be integrally formed on a first substrate 509A, and the first capacitor 394 and the second capacitor 396 may be formed on a second substrate 511A, with terminals 395, 397 as part of driver and bias circuitry 301. In other embodiments, the first transistor 110 and the second transistor 120 may be formed on first substrate 509A, and the first capacitor and the second capacitor may be formed on the first substrate 509A (not shown). Analogously, and in an embodiment, the third transistor 130 and the fourth transistor 140 may be integrally formed on a third substrate 509B, and the first capacitor 494 and the second capacitor 496 may be formed on a fourth substrate 511B with terminals 495, 497, respectively, and as part of driver and bias circuitry 401.

An embodiment may include driver and bias circuitry 301, 401 that includes transistors 330, 430 formed on the third and fourth substrates 509B, 511B wherein the driver amplifier may be electrically coupled to the first terminal of the first capacitor and may be coupled to the third terminal of the second capacitor. The first bias network 370 and the second bias network 380 may be formed on the second substrate 511A, according to an embodiment. The third bias network 470 and the fourth bias network 480 may be formed on the fourth substrate 511B, according to an embodiment. Terminals 328, 348 and 428, 448 that provide biasing to transistors 330 and 430 may be coupled to module terminals 528A, 548A and 528B, and 548B, respectively for connections to external power supplies.

In an embodiment, a splitter 153 may be formed over the base substrate 510 having a splitter input 155 and a first splitter output 156 and a second splitter output 157 and configured to divide a signal delivered to the splitter input 155 between the first splitter output 156 and the second splitter output 157 with a splitter phase difference between the first splitter output and the second splitter output, wherein a difference between the splitter phase difference and the phase shift associated with transmission line 150 is less than twenty percent, wherein the first input terminal 102 may be electrically coupled to the first splitter output 156 and the second input terminal 106 is electrically coupled to the second splitter output 157. Expressing this differently, the phase shift of the transmission line 150 may approximate the splitter phase difference such that their difference is less than about twenty percent. As used herein, the "phase shift of [a] transmission line" means the phase shift encountered by a signal and includes the effect of the phase shift of the transmission line and any loading of the transmission line by other circuit components (e.g., capacitances and inductances). Thus, in an embodiment, the phase shift of the transmission line 150 also includes the effect of output capacitances of third transistor 130 and fourth transistor 140 and/or additional matching elements (not shown) seen at output terminal 137. The first power amplifier device 300 may be configured as a carrier amplifier and the second power amplifier device 400 may be configured as a peaking amplifier in a Doherty amplifier configuration, according to an embodiment. In an embodiment, splitter 153 may be realized using a compact hybrid coupler wherein branches of the compact hybrid coupler are realized in a compact form-factor using lumped element capacitors 558, inductors 559, and termination resistor 554. A coupling capacitor 555 may RF couple second splitter output 157 to the second power amplifier device 400. In other embodiments, the splitter 153 may be realized using a branch line coupler. In other embodiments, the splitter 153 may be realized using a Lange coupler. In still other embodiments, the splitter 153 may be realized using a Wilkinson power divider with and extra transmission line length used to achieve a phase difference between the first splitter output 156 and the second splitter output 157. Splitter input 155 may be coupled to module input 502 with coupling capacitor 504.

Referring to FIGs 5A and 5B, base substrate 510 may include a multi-layer structure that includes a first ground plane layer 512, a first metal layer 514, a second ground plane layer 516, a second metal layer 518, and third metal layer 520, according to an embodiment. In an embodiment, first vias 513 may connect first ground plane layer to first metal layer 514. Second vias 515 may connect first metal layer 514 to second ground plane layer 516, according to an embodiment. In an embodiment, third vias 517 may connect second ground plane layer 516 to second metal layer 518. Fourth vias 519 may connect second metal layer 518 to third metal layer 520, according to an embodiment. By stacking first ground plane layer 512, first metal layer 514, second ground plane layer 516, second metal layer 518, and third metal layer 520 using first, second, third, and fourth vias 513, 515, 517, and 519, heatsink regions 522 and 524 may be created under driver and bias circuitry 301 and first amplifier 101, according to an embodiment. In an embodiment, first ground plane layer 512 may be used to realize microstrip lines (e.g., transmission line 150) in conjunction with third metal layer 520. Second ground plane 516 layer may be used in conjunction with third metal layer 520 to realize transmission lines of narrower width (e.g., splitter input 155 and second output 157).

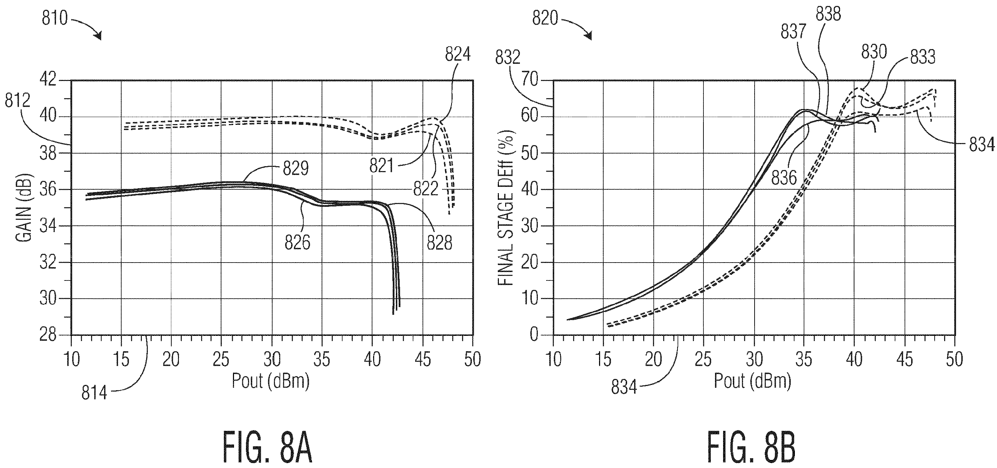

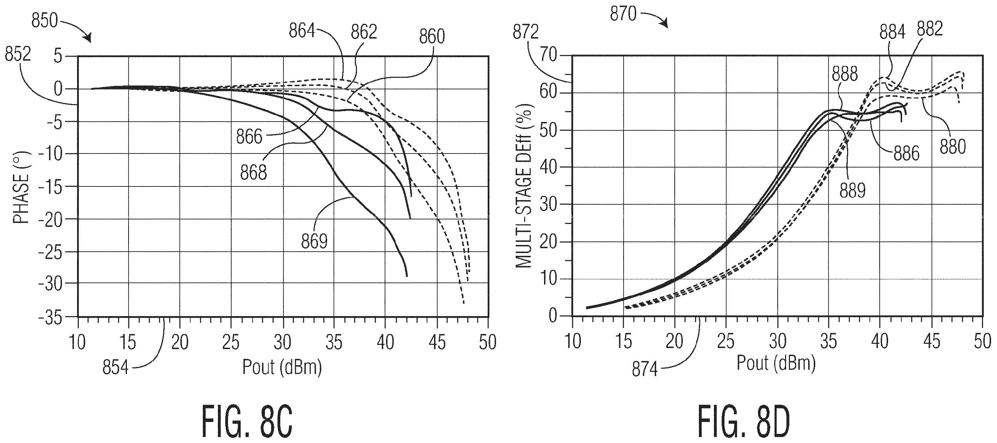

FIGs 8A, 8B, 8C, and 8D, referred to collectively as FIG. 8, are graphical representations 810, 820, 850, 870 depicting simulated operation of the apparatus 500 of FIG. 5. According to an embodiment, graphs 810, 820, 850, 870 depict gain 812, final stage efficiency 832, insertion phase 852, and multi-stage efficiency 872 versus average output power 814, 834, 854, 874 for apparatus 500. Traces 821, 822, 824, 830, 833, 834, 860, 862, 864, 880, 882, 884, depict gain, efficiency, normalized insertion phase, and multi-stage efficiency of performance in a high-power mode. Trios of traces 821-824, 830-834, 860-864, 880-884 represent performance at 2.5, 2.6, and 2.7 GHz, respectively. In the high-power mode, bias conditions include a 48V bias applied to drain terminals 114, 124, 134, 144 of first and second power amplifier devices 300 and 400 with a quiescent current (I_{DQ}) of 18 mA evenly divided between first and second transistors 110, 120 for the first power amplifier device 300 and a gate bias of -3.9V applied to third and fourth gate terminals 132, 142, of third and fourth transistors 130, 140, according to an embodiment. In an embodiment, traces 826, 828, 829, 836, 837, 838, 866, 868, 869, 886, 888, 889 depict gain, efficiency, insertion phase, and multi-stage efficiency versus average output power for apparatus 500 in a low-power mode. Trios of traces 826-829, 836-838, 866-869, 886-889 represent 2.5, 2.6, and 2.7 GHz, respectively. In the low-power mode, bias conditions include a 28V bias applied to drain terminals 114, 124, 134, 144 of first and second power amplifier devices 300 and 400 with a quiescent current (I_{DQ}) of 8.5 mA for first transistor 110, 0 mA for second transistor 120 due to a gate bias of - 8V applied to second gate 122 through second bias network 380 for the first power amplifier device 300 and a gate bias of -3.9V applied to third gate terminal 132 of third transistor 130, and a gate bias of -8V applied to gate of fourth transistor 140, according to an embodiment. Because second and fourth transistors are biased in deep class C, they are effectively "off" while first and third transistors operate in class AB and class C, according to an embodiment.

In FIG. 8A, graph 810 shows transducer gain (Gr) expressed in dB versus output power in decibels with respect to 1 milliwatt (dBm). Traces 826-829 corresponding to low-power operation with first and third transistors 110 and 130 biased in class AB and class C, respectively, both at 28V drain voltage and second and fourth transistors 120 and 140 biased off, also at 28V drain voltage, show approximately 3 dB less gain from 15 to 40 dBm output power than traces 820-824 corresponding to first and second transistors 110, 120 biased in class AB, third, and fourth transistors 130, 140, biased in class C, all operating in the high-power state, all with 48V drain voltage.

In FIG. 8B, graph 820 shows final stage drain efficiency in percent, versus output power in dBm. At an output power of 35 dBm, traces 830-839 corresponding to low-power operation with first and third transistors 110 and 130 biased in class AB and class C, respectively, both at 28V drain voltage and second and fourth transistors 120 and 140 biased off, also at 28V drain voltage show approximately 20 percentage points higher efficiency than traces 830-839 corresponding to first and second transistors 110, 120 biased in class AB and third and fourth transistors 130, 140, biased class C in the high-power state all biased with a 48V drain voltage.

In FIG. 8C, graph 850 shows insertion phase distortion in degrees in response to amplitude modulation (AM-PM) versus output power in dBm. Traces 866-869 corresponding to low-power operation with first and third transistors 110 and 130 biased in class AB and class C, respectively, both at 28V drain voltage and second and fourth transistors 120 and 140 biased off, also at 28V drain voltage, show approximately 3-12 degrees increased AM-PM distortion compared to traces 860-864 corresponding to first and second transistors 110, 120, biased in class AB and third, and fourth transistors 130, 140 biased in class C, in the high-power state all biased with a 48V drain voltage.

In FIG. 8D graph 870 shows multi-stage stage drain efficiency in percent versus output power in dBm. At an output power of 35 dBm, traces 886-889 corresponding to low-power operation with first and third transistors 110 and 130 biased in class AB and class C, respectively, both at 28V drain voltage and second and fourth transistors 120 and 140 biased off, also at 28V drain voltage, show approximately 10-12 percentage points higher efficiency than traces 880-884 corresponding to first and second transistors 110, 120, biased in class AB and third and fourth transistors 130, 140 biased in class C in the high-power state, all biased with a 48V drain voltage.

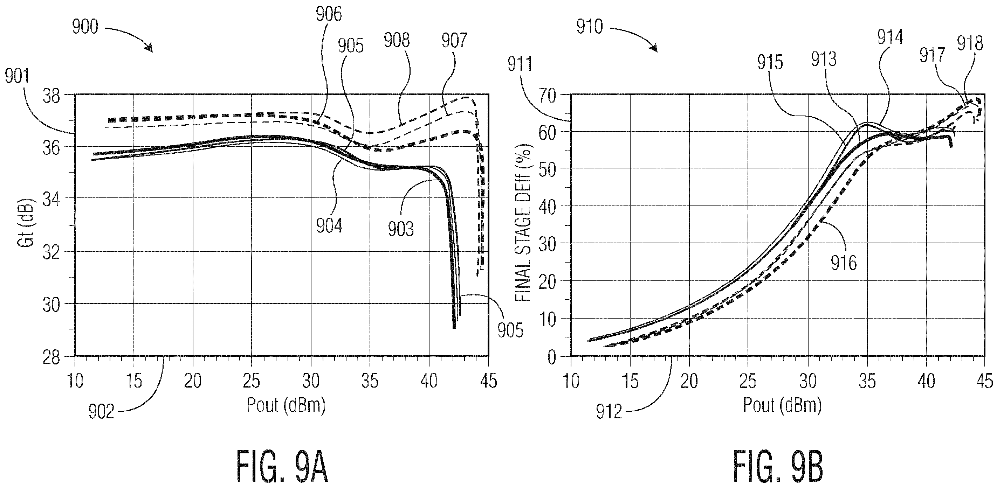

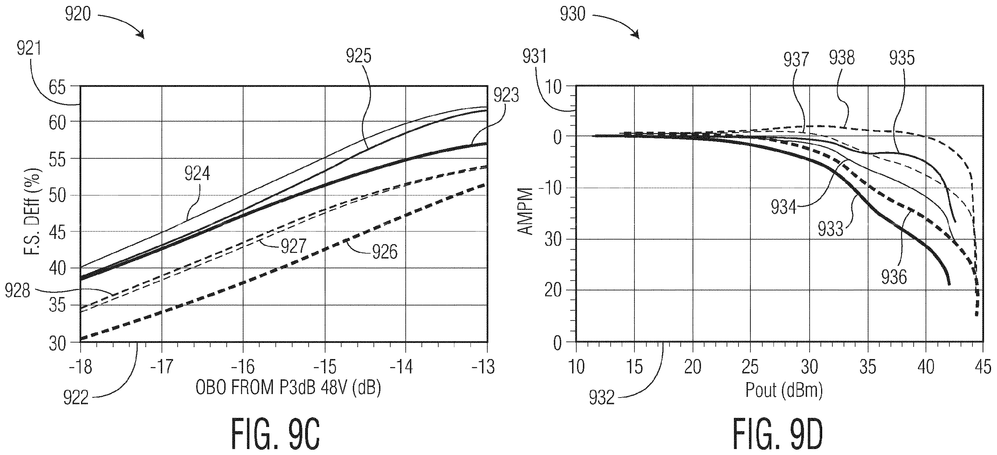

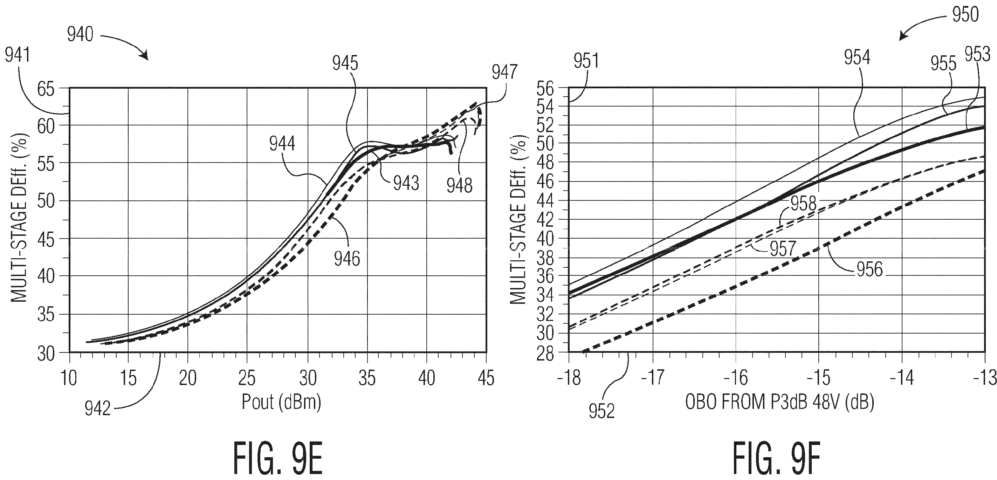

FIGs 9A, 9B, 9C, 9D, 9E, and 9F, referred to collectively as FIG. 9, are graphical representations 900, 910, 920, 930, 940, 950 depicting simulated operation of the apparatus 500 of FIG. 5. According to an embodiment, graphs 900, 910, 920, 930, 940, and 950 depict gain, final stage drain efficiency, AM-PM, final stage drain efficiency, multi-stage drain efficiency, and three stage drain efficiency in low-power mode (i.e. first and third transistors 110, 130 operating in class AB and class C and second and fourth transistors 120, 140 are biased off) to apparatus 500 configured with all transistors active at 28V to compare performance. Traces 903, 904, 905, 906, 907, 908, 913, 914, 915, 916, 917, 918, 923, 924, 925, 926, 927, 928, 933, 934, 935, 936, 937, 938, 943, 944, 945, 946, 947, 948, 953, 954, 955, 956, 957, and 958 are arranged so that each trio of traces (e.g. 903-905, 906-908, 913-915, 916-918, 923-925, 926-928, 933-935, 936-938, 943-945, 946-948, 953-955, and 956-958) represent performance at 2.5 GHz, 2.6 GHz, and 2.7 GHz, respectively. Here, like the traces of FIG. 8 in the low-power mode, bias conditions include a 28V bias applied to drain terminals 114, 124, 134, 144 of first and second power amplifier devices 300 and 400 with a quiescent current (I_{DQ}) of 8.5 mA for first transistor 110, 0 mA for second transistor 120 due to a gate bias of -8V applied to second gate 122 through second bias network 380 for the first power amplifier device 300 and a gate bias of -3.9V applied to third gate terminal 132 of third transistor 130, and a gate bias of -8V applied to gate of fourth transistor 140, according to an embodiment.

In FIG. 9A, graph 900 shows transducer gain (Gr) 901 expressed in dB versus output power 902 in dBm. Traces 903-905 corresponding to low-power operation with first and third transistors 110 and 130 biased in class AB and class C, respectively, both at 28V drain voltage and second and fourth transistors 120 and 140 biased off, also at 28V drain voltage show approximately 1 dB less gain from 15 to 40 dBm output power than traces 906-908 corresponding to first and second transistors 110, 120 biased in class AB and third and fourth transistors, 130, 140 biased in class C, all biased at 28 V drain voltage in the high-power state.

In FIG. 9B, graph 910 shows final stage drain efficiency 911 in percent, versus output power 912 in dBm. At an output power of 35 dBm, traces 913-915 corresponding to low-power operation with first and third transistors 110 and 130 biased in class AB and class C, respectively, both at 28V drain voltage second and fourth transistors 120 and 140 biased off, also at 28V drain voltage show approximately 3-5 percentage points higher efficiency than traces 916-918 corresponding to first and second transistors 110, 120 biased in class AB and third and fourth transistors, 130, 140 biased in class C, all biased at 28 V drain voltage in the high-power state.

In FIG. 9C, graph 920 shows final stage drain efficiency 921 in percent versus output backed off power (OBO) 922 in dB with the saturated power of high-power 48V state of FIG. 8 as a reference. Traces 923-925 corresponding to low-power operation with first and third transistors 110 and 130 biased in class AB and class C, respectively, both at 28V drain voltage and second and fourth transistors 120 and 140 biased off, also at 28V drain voltage, show approximately 5-10 percentage points higher efficiency as a function of back-off power than traces 926-928 corresponding to first and second transistors 110, 120 biased in class AB and third and fourth transistors, 130, 140 biased in class C, all biased at 28 V drain voltage in the high-power state.

In FIG. 9D, graph 930 shows insertion phase modulation in degrees in response to amplitude modulation (AM-PM) 931 versus output power 932 in dBm. Traces 933-935 corresponding to low-power operation with first and third transistors 110 and 130 biased in class AB and class C, respectively, both at 28V drain voltage and second and fourth transistors 120 and 140 biased off, also at 28V drain voltage, show approximately 3-5 degrees increased AM-PM distortion compared to traces 936-938 corresponding to first and second transistors 110, 120 biased in class AB and third and fourth transistors, 130, 140 biased in class C, all biased at 28 V drain voltage in the high-power state.

In FIG. 9E, graph 940 shows multi-stage drain efficiency 941 in percent, versus output power 942 in dBm. At an output power of 35 dBm, traces 943-945 corresponding to low-power operation with first and third transistors 110 and 130 biased in class AB and class C, respectively, both at 28V drain voltage and second and fourth transistors 120 and 140 biased off, also at 28V drain voltage, show approximately three percentage points higher efficiency than traces 946-948 corresponding to first and second transistors 110, 120 biased in class AB and third and fourth transistors, 130, 140 biased in class C, all biased at 28 V drain voltage in the low- power state.

In FIG. 9F, graph 950 shows multi-stage drain efficiency 951 in percent, versus output power back off 952 in dB with the saturated output power of the 48V high-power state as a reference. At a 10 dB back off level, traces 953-955 corresponding to low-power operation with first and third transistors 110 and 130 biased in class AB and class C, respectively, both at 28V drain voltage and second and fourth transistors 120 and 140 biased off also at 28V drain voltage, show approximately 4-5 percentage points higher efficiency than traces 956-958 corresponding to first and second transistors 110, 120 biased in class AB and third and fourth transistors, 130, 140 biased in class C, all biased at 28 V drain voltage in the high-power state.

An amplifier device includes a first input terminal, a second input terminal, a first transistor having a first control electrode and first and second current-carrying electrodes, wherein the first control electrode is radio frequency (RF) coupled to the first input terminal and DC-coupled to a first bias network electrically coupled to the first control electrode, wherein the first bias network is configured to apply a first direct current (DC) bias to the first control electrode and is RF-isolated from the first control electrode. The amplifier device further includes a second transistor that includes a second control electrode that is RF coupled to the second input terminal and a second bias network electrically coupled to the second transistor, wherein the second bias network is configured to apply a second DC bias to the second transistor and is RF-isolated from the second transistor.

For the sake of brevity, certain terminology may also be used herein for the purpose of reference only, and thus are not intended to be limiting, and the terms "first," "second" and other such numerical terms referring to structures do not imply a sequence or order unless clearly indicated by the context.

As used herein, a "node" means any internal or external reference point, connection point, junction, signal line, conductive element, or the like, at which a given signal, logic level, voltage, data pattern, current, or quantity is present. Furthermore, two or more nodes may be realized by one physical element (and two or more signals can be multiplexed, modulated, or otherwise distinguished even though received or output at a common node).

The foregoing description refers to elements or nodes or features being "connected" or "coupled" together. As used herein, unless expressly stated otherwise, "connected" means that one element is directly joined to (or directly communicates with) another element, and not necessarily mechanically. Likewise, unless expressly stated otherwise, "coupled" means that one element is directly or indirectly joined to (or directly or indirectly communicates with) another element, and not necessarily mechanically. Thus, although the schematic shown in the figures depict one exemplary arrangement of elements, additional intervening elements, devices, features, or components may be present in an embodiment of the depicted subject matter.

While at least one exemplary embodiment has been presented in the foregoing detailed description, it should be appreciated that a vast number of variations exist. It should also be appreciated that the exemplary embodiment or embodiments described herein are not intended to limit the scope, applicability, or configuration of the claimed subject matter in any way. Rather, the foregoing detailed description will provide those skilled in the art with a convenient road map for implementing the described embodiment or embodiments. It should be understood that various changes can be made in the function and arrangement of elements without departing from the scope defined by the claims.

## Claims

1. An amplifier device (100) comprising:
a first amplifier (101) electrically coupled to a first input terminal (102, 302) and to a first output terminal (127), wherein the first amplifier (101) includes:
a first transistor (110) that includes a first control electrode (112), a first current-carrying electrode (114), and a second current carrying electrode (116), configured to support a current flow between a first-current-carrying electrode (114) and the second current-carrying electrode (116), wherein the first control electrode (112) is configured to control the current flow between first current-carrying electrode (114) and the second current-carrying electrode (116), wherein the first control electrode (112) is radio frequency ,RF, coupled to the first input terminal (102, 302), and wherein the first current-carrying electrode (114) is electrically coupled to the first output terminal (127);
a first bias network (118, 370) electrically coupled to the first control electrode (112), wherein the first bias network (118, 370) is configured to apply a first direct current ,DC, bias to the first control electrode (112) and is RF-isolated from the first control electrode (112);
a second transistor (120) that includes a second control electrode (122), a third current-carrying electrode (124) and a fourth current carrying electrode (126), configured to support a current flow between a third-current-carrying electrode (124) and the fourth current-carrying electrode (126), wherein the second control electrode (122) is configured to control the current flow between third current-carrying electrode (124) and the fourth current-carrying electrode (126), wherein the second control electrode (122) is RF coupled to the first input terminal (102, 302), wherein the third current-carrying electrode (124) is electrically coupled to the first output terminal (127); and
a second bias network (128, 380) electrically coupled to the second control electrode (122), wherein the second bias network (128, 380) is configured to apply a second DC bias to the second control electrode (122) and is RF-isolated from the second control electrode (122) , the amplifier device (100) further comprising:
a second amplifier (105) electrically coupled to a second input terminal (106, 402) and a second output terminal (137), wherein the second amplifier (105) includes:
a third transistor (130) that includes a third control electrode (132), a fifth current-carrying electrode (134) and a sixth current carrying electrode (136), configured to support a current flow between a fifth-current-carrying electrode (134) and the sixth current-carrying electrode (136), wherein the third control electrode (132) is configured to control the current flow between the fifth current-carrying electrode (134) and the sixth current-carrying electrode (136), wherein the third control electrode (132) is RF coupled to the second input terminal (106, 402), and wherein the fifth current-carrying electrode is electrically coupled to the second output terminal (137);
a third bias network (138, 470) electrically coupled to the third control electrode (132), wherein the third bias network (138, 470) is configured to apply a third DC bias to the third control electrode (132) and is RF-isolated from the third control electrode (132);
a fourth transistor (140) that includes a fourth control electrode (140), a seventh current-carrying electrode (144) and an eighth current carrying electrode (146), configured to support a current flow between a seventh-current-carrying electrode (144) and the eighth current-carrying electrode (146), wherein the fourth control electrode (140) is configured to control the current flow between seventh current-carrying electrode (144) and the eighth current-carrying electrode (146), wherein the fourth control electrode (140) is radio frequency ,RF, coupled to the second input terminal (106, 402), and wherein the seventh current-carrying electrode (144) is electrically coupled to the second output terminal (137); and
a fourth bias network (148, 480) electrically coupled to the fourth control electrode (140), wherein the fourth bias network (148, 480) is configured to apply a fourth DC bias to the fourth control electrode (140) and is RF-isolated from the fourth control electrode (140),
wherein the first amplifier (101) is configured as a carrier amplifier and the second amplifier (105) is configured as a peaking amplifier in a Doherty amplifier configuration, wherein:
the first amplifier (101) is configured to operate in a first state and to operate in a second state, wherein:
when in the first state, the first transistor (110) and the second transistor (120) are configured to operate with a first bias (119) applied to the first bias network (118, 370), a second bias (129) applied to the second bias network (128, 380) such that the first bias (119) and second bias (129) allow an RF current of an least fifty percent of a maximum current of the second transistor (120) flows through the second transistor (120) when the first transistor (110) is operated at a saturated output power, and a third bias (139) applied to the first current-carrying electrode (114) and to the third current-carrying electrode (124); and
when in the second state, the first transistor (110) and the second transistor (120) are configured to operate with the first bias (119) applied to the first bias network (118, 370), a fourth bias (149) applied to the second bias network (128, 380) such that the fourth bias (149) allows an RF current of less than ten percent of a maximum current of the second transistor (120) to flow from the third current-carrying electrode (124) of the second transistor (120) to the fourth current-carrying electrode (126) of the second transistor (120) when the first transistor (110) is operated at a saturated output power with a current of greater than fifty percent of a maximum current of the first transistor (110), and a fifth bias (109) applied to the first current-carrying electrode (114) and to the third current-carrying electrode (124).

2. The amplifier device (100) of claim 1, further comprising:
a transmission line (150) having a phase shift and configured to electrically couple the first output terminal (127) and the second output terminal (137); and
an impedance transformer (152) electrically coupled to a summing node at the group consisting of the first output terminal (127) and the second output terminal (137).

3. The amplifier device (100) of claim 2, further comprising a splitter device (153) having a splitter input (155) and a first splitter output (156) and a second splitter output (157) and configured to divide a signal delivered to the splitter input (155) between the first splitter output (156) and the second splitter output (157) with a phase difference between the first splitter output (156) and the second splitter output (157), wherein a difference between the phase difference and the phase shift of the transmission line (150) is less than twenty percent, wherein the first input terminal (102, 302) is electrically coupled to the first splitter output (156) and the second input terminal (106, 402) is electrically coupled to the second splitter output (157).

4. The amplifier device (100) of any preceding claim, wherein the first transistor (110) is configured as a field effect transistor, wherein:
the first control electrode (112) is configured as a gate electrode;
the first current-carrying electrode (114) is configured as a drain electrode; and the second current-carrying element (116) is configured as a source electrode.

5. The amplifier device (100) of any preceding claim, further comprising:
a first coupling element (394) having a first terminal (394A) and a second terminal (394B), wherein the second terminal (394B) is electrically coupled to the first control electrode (112); and
a second coupling element (396) having a third terminal (396A) and a fourth terminal (396B), wherein the fourth terminal (396B) is electrically coupled to the second control electrode (122), and wherein the first terminal (394A) is electrically coupled to the third terminal (396A).

6. The amplifier device (100) of claim 5, wherein a driver amplifier (308) comprising a transistor (330) is electrically coupled to the first terminal (394A) of the first coupling element (394) and to the third terminal (396A) of the second coupling element (396).

7. The amplifier device (100) of claim 5 or 6, further comprising a first input matching network, configured to provide an impedance match for the first transistor (110) at a fundamental frequency is coupled to the first control electrode (112) and a second input matching network, configured to provide an impedance match for the second transistor (120) at a fundamental frequency is coupled to the second control electrode (122).

8. The amplifier device (100) of any of claims 5 to 7, further comprising a first input harmonic matching network (350), configured to provide a harmonic termination for the first transistor (110) at a harmonic frequency, and a second harmonic matching network (360), configured to provide a harmonic termination for the second transistor (120) at the harmonic frequency.

9. The amplifier device (100) of any of claims 5 to 8, further comprising:
a base substrate (510);
a first amplifier die (300) comprising the first amplifier (101) coupled to the base substrate and electrically coupled to a first input terminal (102, 302) and to a first output terminal (127); wherein the first coupling element (394) comprises a first capacitor and the second coupling element (396) comprises a second capacitor.

10. The amplifier device (100) of claim 9, wherein the first transistor (110) and the second transistor (120) are formed on a first substrate (509A), and wherein the first capacitor (394) and the second capacitor (396) are formed on the first substrate (509A).

11. The amplifier device (100) of claim 9, wherein the first transistor (110) and the second transistor (120) are formed on a first substrate (509A), and wherein the first capacitor (394) and the second capacitor (396) are formed on a second substrate (511A).

## Patentansprüche

1. Verstärkervorrichtung (100), die Folgendes umfasst:
einen ersten Verstärker (101), der elektrisch mit einem ersten Eingangsanschluss (102, 302) und mit einem ersten Ausgangsanschluss (127) gekoppelt ist, wobei der erste Verstärker (101) Folgendes beinhaltet:
einen ersten Transistor (110), der eine erste Steuerelektrode (112), eine erste stromführende Elektrode (114) beinhaltet, und eine zweite stromführende Elektrode (116), die dazu ausgelegt ist, einen Stromfluss zwischen einer ersten stromführenden Elektrode (114) und der zweiten stromführenden Elektrode (116) zu unterstützen, wobei die erste Steuerelektrode (112) dazu ausgelegt ist, den Stromfluss zwischen der ersten stromführenden Elektrode (114) und der zweiten stromführenden Elektrode (116) zu steuern, wobei die erste Steuerelektrode (112) mit dem ersten Eingangsanschluss (102, 302) Hochfrequenz-gekoppelt, HF-gekoppelt, ist, und wobei die erste stromführende Elektrode (114) elektrisch mit dem ersten Ausgangsanschluss (127) gekoppelt ist;
ein erstes Vorspannungsnetzwerk (118, 370), das elektrisch mit der ersten Steuerelektrode (112) gekoppelt ist, wobei das erste Vorspannungsnetzwerk (118, 370) dazu ausgelegt ist, eine erste Gleichstrom-Vorspannung, DC-Vorspannung, an die erste Steuerelektrode (112) anzulegen und von der ersten Steuerelektrode (112) HF-isoliert ist;
einen zweiten Transistor (120), der eine zweite Steuerelektrode (122), eine dritte stromführende Elektrode (124) und eine vierte stromführende Elektrode (126) beinhaltet, die dazu ausgelegt sind, einen Stromfluss zwischen einer dritten stromführenden Elektrode (124) und der vierten stromführenden Elektrode (126) zu unterstützen, wobei die zweite Steuerelektrode (122) dazu ausgelegt ist, den Stromfluss zwischen der dritten stromführenden Elektrode (124) und der vierten stromführenden Elektrode (126) zu steuern, wobei die zweite Steuerelektrode (122) mit dem ersten Eingangsanschluss (102, 302) HF-gekoppelt ist, wobei die dritte stromführende Elektrode (124) elektrisch mit dem ersten Ausgangsanschluss (127) gekoppelt ist; und
ein zweites Vorspannungsnetzwerk (128, 380), das elektrisch mit der zweiten Steuerelektrode (122) gekoppelt ist, wobei das zweite Vorspannungsnetzwerk (128, 380) dazu ausgelegt ist, eine zweite DC-Vorspannung an die zweite Steuerelektrode (122) anzulegen und von der zweiten Steuerelektrode (122) HF-isoliert ist, wobei die Verstärkervorrichtung (100) ferner Folgendes umfasst:
einen zweiten Verstärker (105), der elektrisch mit einem zweiten Eingangsanschluss (106, 402) und einem zweiten Ausgangsanschluss (137) gekoppelt ist, wobei der zweite Verstärker (105) Folgendes beinhaltet:
einen dritten Transistor (130), der eine dritte Steuerelektrode (132), eine fünfte stromführende Elektrode (134) und eine sechste stromführende Elektrode (136) beinhaltet, die dazu ausgelegt sind, einen Stromfluss zwischen einer fünften stromführenden Elektrode (134) und der sechsten stromführenden Elektrode (136) zu unterstützen, wobei die dritte Steuerelektrode (132) dazu ausgelegt ist, den Stromfluss zwischen der fünften stromführenden Elektrode (134) und der sechsten stromführenden Elektrode (136) zu steuern, wobei die dritte Steuerelektrode (132) mit dem zweiten Eingangsanschluss (106, 402) HF-gekoppelt ist, und wobei die fünfte stromführende Elektrode elektrisch mit dem zweiten Ausgangsanschluss (137) gekoppelt ist;
ein drittes Vorspannungsnetzwerk (138, 470), das elektrisch mit der dritten Steuerelektrode (132) gekoppelt ist, wobei das dritte Vorspannungsnetzwerk (138, 470) dazu ausgelegt ist, eine dritte DC-Vorspannung an die dritte Steuerelektrode (132) anzulegen und von der dritten Steuerelektrode (132) HF-isoliert ist;
einen vierten Transistor (140), der eine vierte Steuerelektrode (140), eine siebte stromführende Elektrode (144) und eine achte stromführende Elektrode (146) beinhaltet, die dazu ausgelegt sind, einen Stromfluss zwischen einer siebten stromführenden Elektrode (144) und der achten stromführenden Elektrode (146) zu unterstützen, wobei die vierte Steuerelektrode (140) dazu ausgelegt ist, den Stromfluss zwischen der siebten stromführenden Elektrode (144) und der achten stromführenden Elektrode (146) zu steuern, wobei die vierte Steuerelektrode (140) mit dem zweiten Eingangsanschluss (106, 402) Hochfrequenz-gekoppelt, HF-gekoppelt, ist und wobei die siebte stromführende Elektrode (144) elektrisch mit dem zweiten Ausgangsanschluss (137) gekoppelt ist; und
ein viertes Vorspannungsnetzwerk (148, 480), das elektrisch mit der vierten Steuerelektrode (140) gekoppelt ist, wobei das vierte Vorspannungsnetzwerk (148, 480) dazu ausgelegt ist, eine vierte DC-Vorspannung an die vierte Steuerelektrode (140) anzulegen und von der vierten Steuerelektrode (140) HF-isoliert ist,
wobei der erste Verstärker (101) als ein Trägerverstärker ausgelegt ist und der zweite Verstärker (105) als ein Peaking-Verstärker in einer Doherty-Verstärkerkonfiguration ausgelegt ist, wobei:
der erste Verstärker (101) dazu ausgelegt ist, in einem ersten Zustand zu arbeiten und in einem zweiten Zustand zu arbeiten, wobei:
wenn in dem ersten Zustand, der erste Transistor (110) und der zweite Transistor (120) dazu ausgelegt sind , mit einer ersten Vorspannung (119), die an das erste Vorspannungsnetzwerk (118, 370) angelegt wird, einer zweiten Vorspannung (129), die an das zweite Vorspannungsnetzwerk (128, 380) angelegt wird, so dass die erste Vorspannung (119) und die zweite Vorspannung (129) ermöglichen, dass ein HF-Strom von mindestens fünfzig Prozent eines maximalen Stroms des zweiten Transistors (120) durch den zweiten Transistor (120) fließt, wenn der erste Transistor (110) mit einer gesättigten Ausgangsleistung betrieben wird, und einer dritten Vorspannung (139) zu arbeiten, die an die erste stromführende Elektrode (114) und an die dritte stromführende Elektrode (124) angelegt wird; und
wenn in dem zweiten Zustand, der erste Transistor (110) und der zweite Transistor (120) dazu ausgelegt sind, mit der ersten Vorspannung (119), die an das erste Vorspannungsnetzwerk (118, 370) angelegt wird, einer vierten Vorspannung (149), die an das zweite Vorspannungsnetzwerk (128, 380) angelegt wird, so dass die vierte Vorspannung (149) ermöglicht, dass ein HF-Strom von weniger als zehn Prozent eines maximalen Stroms des zweiten Transistors (120) von der dritten stromführenden Elektrode (124) des zweiten Transistors (120) zu der vierten stromführenden Elektrode (126) des zweiten Transistors (120) fließt, wenn der erste Transistor (110) mit einer gesättigten Ausgangsleistung mit einem Strom von mehr als fünfzig Prozent eines maximalen Stroms des ersten Transistors (110) betrieben wird, und einer fünften Vorspannung (109) zu arbeiten, die an die erste stromführende Elektrode (114) und an die dritte stromführende Elektrode (124) angelegt ist.

2. Verstärkervorrichtung (100) nach Anspruch 1, die ferner Folgendes umfasst:
eine Übertragungsleitung (150), die eine Phasenverschiebung aufweist und dazu ausgelegt ist, den ersten Ausgangsanschluss (127) und den zweiten Ausgangsanschluss (137) elektrisch zu koppeln; und
einen Impedanzwandler (152), der elektrisch mit einem Summierknoten an der Gruppe gekoppelt ist, die aus dem ersten Ausgangsanschluss (127) und dem zweiten Ausgangsanschluss (137) besteht.

3. Verstärkervorrichtung (100) nach Anspruch 2, die ferner eine Splittervorrichtung (153) mit einem Splittereingang (155) und einem ersten Splitterausgang (156) und einem zweiten Splitterausgang (157) umfasst, und die dazu ausgelegt ist, ein an den Splittereingang (155) geliefertes Signal zwischen dem ersten Splitterausgang (156) und dem zweiten Splitterausgang (157) mit einer Phasendifferenz zwischen dem ersten Splitterausgang (156) und dem zweiten Splitterausgang (157) zu teilen, wobei eine Differenz zwischen der Phasendifferenz und der Phasenverschiebung der Übertragungsleitung (150) weniger als zwanzig Prozent beträgt, wobei der erste Eingangsanschluss (102, 302) elektrisch mit dem ersten Splitterausgang (156) gekoppelt ist und der zweite Eingangsanschluss (106, 402) elektrisch mit dem zweiten Splitterausgang (157) gekoppelt ist.

4. Verstärkervorrichtung (100) nach einem der vorhergehenden Ansprüche, wobei der erste Transistor (110) als ein Feldeffekttransistor ausgelegt ist, wobei:
die erste Steuerelektrode (112) als eine Gate-Elektrode ausgelegt ist;
die erste stromführende Elektrode (114) als eine Drain-Elektrode ausgelegt ist; und das zweite stromführende Element (116) als eine Source-Elektrode ausgelegt ist.

5. Verstärkervorrichtung (100) nach einem der vorhergehenden Ansprüche, die ferner Folgendes umfasst:
ein erstes Kopplungselement (394) mit einem ersten Anschluss (394A) und einem zweiten Anschluss (394B), wobei der zweite Anschluss (394B) elektrisch mit der ersten Steuerelektrode (112) gekoppelt ist; und
ein zweites Kopplungselement (396) mit einem dritten Anschluss (396A) und einem vierten Anschluss (396B), wobei der vierte Anschluss (396B) elektrisch mit der zweiten Steuerelektrode (122) gekoppelt ist und wobei der erste Anschluss (394A) elektrisch mit dem dritten Anschluss (396A) gekoppelt ist.

6. Verstärkervorrichtung (100) nach Anspruch 5, wobei ein Treiberverstärker (308), der einen Transistor (330) umfasst, elektrisch mit dem ersten Anschluss (394A) des ersten Kopplungselements (394) und mit dem dritten Anschluss (396A) des zweiten Kopplungselements (396) gekoppelt ist.

7. Verstärkervorrichtung (100) nach Anspruch 5 oder 6, die ferner ein erstes Eingangsanpassungsnetzwerk, das dazu ausgelegt ist, eine Impedanzanpassung für den ersten Transistor (110) bei einer Grundfrequenz bereitzustellen, mit der ersten Steuerelektrode (112) gekoppelt ist, und ein zweites Eingangsanpassungsnetzwerk umfasst, das dazu ausgelegt ist, eine Impedanzanpassung für den zweiten Transistor (120) bei einer Grundfrequenz bereitzustellen, mit der zweiten Steuerelektrode (122) gekoppelt ist.

8. Verstärkervorrichtung (100) nach einem der Ansprüche 5 bis 7, die ferner ein erstes harmonisches Eingangsanpassungsnetzwerk (350), das dazu ausgelegt ist, einen harmonischen Abschluss für den ersten Transistor (110) bei einer harmonischen Frequenz bereitzustellen, und ein zweites harmonisches Anpassungsnetzwerk (360) umfasst, das dazu ausgelegt ist, einen harmonischen Abschluss für den zweiten Transistor (120) bei der harmonischen Frequenz bereitzustellen.

9. Verstärkervorrichtung (100) nach einem der Ansprüche 5 bis 8, die ferner Folgendes umfasst:
ein Grundsubstrat (510);
einen ersten Verstärker-Die (300), der den ersten Verstärker (101) umfasst, der mit dem Grundsubstrat gekoppelt ist und elektrisch mit einem ersten Eingangsanschluss (102, 302) und mit einem ersten Ausgangsanschluss (127) gekoppelt ist; wobei das erste Kopplungselement (394) einen ersten Kondensator umfasst und das zweite Kopplungselement (396) einen zweiten Kondensator umfasst.

10. Verstärkervorrichtung (100) nach Anspruch 9, wobei der erste Transistor (110) und der zweite Transistor (120) auf einem ersten Substrat (509A) gebildet sind und wobei der erste Kondensator (394) und der zweite Kondensator (396) auf dem ersten Substrat (509A) gebildet sind.

11. Verstärkervorrichtung (100) nach Anspruch 9, wobei der erste Transistor (110) und der zweite Transistor (120) auf einem ersten Substrat (509A) gebildet sind und wobei der erste Kondensator (394) und der zweite Kondensator (396) auf einem zweiten Substrat (511A) gebildet sind.

## Revendications

1. Dispositif amplificateur (100), comprenant :
un premier amplificateur (101) couplé électriquement à une première borne d'entrée (102, 302) et à une première borne de sortie (127), dans lequel le premier amplificateur (101) comprend :
un premier transistor (110) qui comprend une première électrode de contrôle (112), une première électrode porteuse de courant (114) et une deuxième électrode porteuse de courant (116), configurées pour prendre en charge un flux de courant entre une première électrode porteuse de courant (114) et la deuxième électrode porteuse de courant (116), dans lequel la première électrode de contrôle (112) est configurée pour contrôler le flux de courant entre la première électrode porteuse de courant (114) et la deuxième électrode porteuse de courant (116), dans lequel la première électrode de contrôle (112) est une fréquence radio, RF, couplée à la première borne d'entrée (102, 302), et dans lequel la première électrode porteuse de courant (114) est couplée électriquement à la première borne de sortie (127) ;
un premier réseau de polarisation (118, 370) couplé électriquement à la première électrode de contrôle (112), dans lequel le premier réseau de polarisation (118, 370) est configuré pour appliquer une première polarisation en courant continu, CC, à la première électrode de contrôle (112) et est isolé en RF de la première électrode de contrôle (112) ;
un deuxième transistor (120) qui comprend une deuxième électrode de contrôle (122), une troisième électrode porteuse de courant (124) et une quatrième électrode porteuse de courant (126), configurées pour prendre en charge un flux de courant entre une troisième électrode porteuse de courant (124) et la quatrième électrode porteuse de courant (126), dans lequel la deuxième électrode de contrôle (122) est configurée pour contrôler le flux de courant entre la troisième électrode porteuse de courant (124) et la quatrième électrode porteuse de courant (126), dans lequel la deuxième électrode de contrôle (122) est une RF couplée à la première borne d'entrée (102, 302), dans lequel la troisième électrode porteuse de courant (124) est couplée électriquement à la première borne de sortie (127) ; et
un deuxième réseau de polarisation (128, 380) couplé électriquement à la deuxième électrode de contrôle (122), dans lequel le deuxième réseau de polarisation (128, 380) est configuré pour appliquer une deuxième polarisation en CC à la deuxième électrode de contrôle (122) et est isolé en RF de la deuxième électrode de contrôle (122), le dispositif amplificateur (100) comprenant en outre :
un second amplificateur (105) couplé électriquement à une deuxième borne d'entrée (106, 402) et à une deuxième borne de sortie (137), dans lequel le second amplificateur (105) comprend :
un troisième transistor (130) qui comprend une troisième électrode de contrôle (132), une cinquième électrode porteuse de courant (134) et une sixième électrode porteuse de courant (136), configurées pour prendre en charge un flux de courant entre une cinquième électrode porteuse de courant (134) et la sixième électrode porteuse de courant (136), dans lequel la troisième électrode de contrôle (132) est configurée pour contrôler le flux de courant entre la cinquième électrode porteuse de courant (134) et la sixième électrode porteuse de courant (136), dans lequel la troisième électrode de contrôle (132) est une RF couplée à la deuxième borne d'entrée (106, 402), et dans lequel la cinquième électrode porteuse de courant est couplée électriquement à la deuxième borne de sortie (137) ;
un troisième réseau de polarisation (138, 470) couplé électriquement à la troisième électrode de contrôle (132), dans lequel le troisième réseau de polarisation (138, 470) est configuré pour appliquer une troisième polarisation en CC à la troisième électrode de contrôle (132) et est isolé en RF de la troisième électrode de contrôle (132) ;
un quatrième transistor (140) qui comprend une quatrième électrode de contrôle (140), une septième électrode porteuse de courant (144) et une huitième électrode porteuse de courant (146), configurées pour prendre en charge un flux de courant entre une septième électrode porteuse de courant (144) et la huitième électrode porteuse de courant (146), dans lequel la quatrième électrode de contrôle (140) est configurée pour contrôler le flux de courant entre la septième électrode porteuse de courant (144) et la huitième électrode porteuse de courant (146), dans lequel la quatrième électrode de contrôle (140) est une fréquence radio, RF, couplée à la deuxième borne d'entrée (106, 402), et dans lequel la septième électrode porteuse de courant (144) est couplée électriquement à la deuxième borne de sortie (137) ; et
un quatrième réseau de polarisation (148, 480) couplé électriquement à la quatrième électrode de contrôle (140), dans lequel le quatrième réseau de polarisation (148, 480) est configuré pour appliquer une quatrième polarisation en CC à la quatrième électrode de contrôle (140) et est isolé en RF de la quatrième électrode de contrôle (140),
dans lequel le premier amplificateur (101) est configuré en tant qu'amplificateur de porteuse et le second amplificateur (105) est configuré en tant qu'amplificateur de crête dans une configuration d'amplificateur Doherty, dans lequel :
le premier amplificateur (101) est configuré pour fonctionner dans un premier état et pour fonctionner dans un second état, dans lequel :
lorsqu'ils sont dans le premier état, le premier transistor (110) et le deuxième transistor (120) sont configurés pour fonctionner avec une première polarisation (119) appliquée au premier réseau de polarisation (118, 370), une deuxième polarisation (129) appliquée au deuxième réseau de polarisation (128, 380) de sorte que la première polarisation (119) et la deuxième polarisation (129) permettent à un courant RF d'au moins cinquante pour cent d'un courant maximal du deuxième transistor (120) de circuler à travers le deuxième transistor (120) lorsque le premier transistor (110) fonctionne à une puissance de sortie saturée, et une troisième polarisation (139) appliquée à la première électrode porteuse de courant (114) et à la troisième électrode porteuse de courant (124) ; et
lorsqu'ils sont dans le second état, le premier transistor (110) et le deuxième transistor (120) sont configurés pour fonctionner avec la première polarisation (119) appliquée au premier réseau de polarisation (118, 370), une quatrième polarisation (149) appliquée au deuxième réseau de polarisation (128, 380) de sorte que la quatrième polarisation (149) permette à un courant RF de moins de dix pour cent d'un courant maximal du deuxième transistor (120) de circuler à partir de la troisième électrode porteuse de courant (124) du deuxième transistor (120) à la quatrième électrode porteuse de courant (126) du deuxième transistor (120) lorsque le premier transistor (110) fonctionne à une puissance de sortie saturée avec un courant de plus de cinquante pour cent d'un courant maximal du premier transistor (110) , et une cinquième polarisation (109) appliquée à la première électrode porteuse de courant (114) et à la troisième électrode porteuse de courant (124).

2. Dispositif amplificateur (100) selon la revendication 1, comprenant en outre :
une ligne de transmission (150) ayant un déphasage et configurée pour coupler électriquement la première borne de sortie (127) et la deuxième borne de sortie (137) ; et
un transformateur d'impédance (152) couplé électriquement à un nœud de sommation au groupe constitué par la première borne de sortie (127) et la deuxième borne de sortie (137).

3. Dispositif amplificateur (100) selon la revendication 2, comprenant en outre un dispositif diviseur (153) ayant une entrée de diviseur (155), une première sortie de diviseur (156) et une seconde sortie de diviseur (157) et configuré pour diviser un signal délivré à l'entrée de diviseur (155) entre la première sortie de diviseur (156) et la seconde sortie de diviseur (157) avec une différence de phase entre la première sortie de diviseur (156) et la seconde sortie de diviseur (157), dans lequel une différence entre la différence de phase et le déphasage de la ligne de transmission (150) est inférieure à vingt pour cent, dans lequel la première borne d'entrée (102, 302) est couplée électriquement à la première sortie de diviseur (156) et la deuxième borne d'entrée (106, 402) est couplée électriquement à la seconde sortie de diviseur (157).

4. Dispositif amplificateur (100) selon l'une quelconque des revendications précédentes, dans lequel le premier transistor (110) est configuré en tant que transistor à effet de champ, dans lequel :
la première électrode de contrôle (112) est configurée en tant qu'électrode de grille ;
la première électrode porteuse de courant (114) est configurée en tant qu'électrode de drain ; et le second élément de transport de courant (116) est configuré en tant qu'électrode de source.

5. Dispositif amplificateur (100) selon l'une quelconque des revendications précédentes, comprenant en outre :
un premier élément de couplage (394) ayant une première borne (394A) et une deuxième borne (394B), dans lequel la deuxième borne (394B) est couplée électriquement à la première électrode de contrôle (112) ; et
un second élément de couplage (396) ayant une troisième borne (396A) et une quatrième borne (396B), dans lequel la quatrième borne (396B) est couplée électriquement à la deuxième électrode de contrôle (122), et dans lequel la première borne (394A) est couplée électriquement à la troisième borne (396A).

6. Dispositif amplificateur (100) selon la revendication 5, dans lequel un amplificateur de pilotage (308) comprenant un transistor (330) est couplé électriquement à la première borne (394A) du premier élément de couplage (394) et à la troisième borne (396A) du second élément de couplage (396).

7. Dispositif amplificateur (100) selon la revendication 5 ou 6, comprenant en outre un premier réseau d'adaptation d'entrée, configuré pour fournir une adaptation d'impédance pour le premier transistor (110) à une fréquence fondamentale, est couplé à la première électrode de contrôle (112) et un second réseau d'adaptation d'entrée, configuré pour fournir une adaptation d'impédance pour le deuxième transistor (120) à une fréquence fondamentale, est couplé à la deuxième électrode de contrôle (122).

8. Dispositif amplificateur (100) selon l'une quelconque des revendications 5 à 7, comprenant en outre un premier réseau d'adaptation d'harmoniques d'entrée (350), configuré pour fournir une terminaison harmonique pour le premier transistor (110) à une fréquence harmonique, et un second réseau d'adaptation d'harmoniques (360), configuré pour fournir une terminaison harmonique pour le deuxième transistor (120) à la fréquence harmonique.

9. Dispositif amplificateur (100) selon l'une quelconque des revendications 5 à 8, comprenant en outre :
un substrat de base (510) ;
une première puce d'amplificateur (300) comprenant le premier amplificateur (101) couplé au substrat de base et couplé électriquement à une première borne d'entrée (102, 302) et à une première borne de sortie (127) ; dans lequel le premier élément de couplage (394) comprend un premier condensateur et le second élément de couplage (396) comprend un second condensateur.

10. Dispositif amplificateur (100) selon la revendication 9, dans lequel le premier transistor (110) et le deuxième transistor (120) sont formés sur un premier substrat (509A), et dans lequel le premier condensateur (394) et le second condensateur (396) sont formés sur le premier substrat (509A).

11. Dispositif amplificateur (100) selon la revendication 9, dans lequel le premier transistor (110) et le deuxième transistor (120) sont formés sur un premier substrat (509A), et dans lequel le premier condensateur (394) et le second condensateur (396) sont formés sur un second substrat (511A).
